(19) Europäisches Patentamt / European Patent Office / Office européen des brevets

(11) **EP 2 628 205 B1**

(12) **EUROPEAN PATENT SPECIFICATION**

(45) Date of publication and mention of the grant of the patent:
**06.01.2021 Bulletin 2021/01**

(51) Int Cl.:
*H01M 10/48* (2006.01)    *H01M 4/00* (2006.01)
*H01M 10/052* (2010.01)   *H01M 10/0585* (2010.01)
*H01M 4/13* (2010.01)     *H01M 6/50* (2006.01)

(21) Application number: **11767719.5**

(22) Date of filing: **12.10.2011**

(86) International application number:
**PCT/EP2011/067787**

(87) International publication number:
**WO 2012/049201 (19.04.2012 Gazette 2012/16)**

(54) **ELECTROCHEMICAL CELL BASED ON LITHIUM TECHNOLOGY WITH INTERNAL REFERENCE ELECTRODE, PROCESS FOR ITS PRODUCTION AND METHODS FOR SIMULTANEOUS MONITORING OF THE VOLTAGE OR IMPEDANCE OF THE ANODE AND THE CATHODE THEREOF**

AUF LITHIUMTECHNOLOGIE BASIERENDE BATTERIEZELLE MIT INTERNER REFERENZELEKTRODE, VERFAHREN ZU IHRER HERSTELLUNG UND VERFAHREN ZUR SIMULTANEN ÜBERWACHUNG DER SPANNUNG UND DER IMPEDANZ IHRER ANODE UND KATHODE

CELLULE ÉLECTROCHIMIQUE UTILISANT LA TECHNOLOGIE LITHIUM AVEC ÉLECTRODE DE RÉFÉRENCE INTERNE, PROCESSUS DE FABRICATION, ET PROCÉDÉS DE CONTRÔLE SIMULTANÉ DE LA TENSION OU DE L'IMPÉDANCE DE L'ANODE ET DE LA CATHODE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.10.2010 EP 10187482**

(43) Date of publication of application:
**21.08.2013 Bulletin 2013/34**

(73) Proprietor: **Fraunhofer-Gesellschaft zur Förderung der angewandten Forschung e.V.**
**80686 München (DE)**

(72) Inventors:
• **WIJAYAWARDHANA, Charles**
  **25526 Wacken (DE)**
• **NEUMANN, Gerold**
  **25469 Halstenbek (DE)**
• **GULDE, Peter**
  **25524 Itzehoe (DE)**

(74) Representative: **Strehl Schübel-Hopf & Partner**
**Maximilianstrasse 54**
**80538 München (DE)**

(56) References cited:
**WO-A2-2009/036444    JP-A- 2007 193 986**
**US-A1- 2007 166 617**

**Description**

The present invention is directed to a lithium battery comprising layered components having an internal reference electrode incorporated therein, in order to alleviate simultaneous monitoring of the voltage and/or the impedance of the anode and the cathode, to provide the possibility that the battery is used at its maximum capacity and with enhanced safety.

A reference electrode is defined as an electrode that has a stable electrochemical potential which serves as a reference point for measuring the potential of one or more electrodes in an electrochemical cell.

In the past, reference electrodes have mainly been used externally. Table 1 below summarizes the key properties of the most important reference electrodes of the prior art and their compatibility with lithium-ion/polymer cells:

| Reference electrode | Reference redox reactions | Chemical compatibility to Li-ion/polymer cells | Manufacturable compatibility to Li-ion/polymer cells | Overall compatibility to Li-ion/olymer cells |
|---|---|---|---|---|
| Silver-silver chloride (Ag/AgCl) | $AgCl + e^- \leftrightarrow Ag + Cl^-$ (0.222 V vs. NHE at 25°C) | Poor | Incompatible | Incompatible |
| Calomel reference electrode (SCE) | $Hg_2Cl_2 + 2e^- \leftrightarrow 2Hg + 2Cl^-$ (0.222 V vs. NHE at 25°C) | Poor | Incompatible | Incompatible |
| Normal hydrogen electrode (NHE) | $2H^+(aq) + 2e^- \rightarrow H_2 (g)$ | Incompatible | Incompatible | Incompatible |
| Pure metal and metal alloy wires | Examples: 1) $Li^+ + e^- \rightarrow Li$ 2) $Ag^+ + e^- \rightarrow Ag$ 3) Pt & Pt-oxide systems | Some compatible (e.g. Li metal) | Incompatible (see text below) | Incompatible |

Of the above, the Ag/AgCl, NHE, and SCE reference electrodes are generally used in electrochemical systems consisting of aqueous electrolytes. Therefore, they are not suitable for direct use in lithium polymer cells which are based on organic solvents. It should be noted, however, that these electrodes can be adapted for use in organic solutions with the use of a double salt bridge (which minimizes mixing of solvents) (US 3,103,480, US 4,282,081, US 4,401,548). In the case of lithium batteries, such electrodes pose special problems. One is that these electrodes are not fully impermeable to mixing, so the inevitable rise in water content in the battery will greatly decrease the performance of the battery. It is well known that water content in a battery must be kept as low as possible (i.e., in the 100 ppm range). Second, there is no foreseeable way in which such a double salt bridge electrode could be physically incorporated in a lithium polymer cell. As noted in Table 1, pure metal or metal alloy wires, too, can be used as reference electrodes. There have been a few journal publications and at least one commercial source where such systems have been reported [(D. W. Dees, A. N. Jansen, D. P. Abrahams, J. Power Sources 174 (2007) 1001) & (www.el-cell.com)] In all these systems, the reference electrode is simply a wire consisting of Li, a lithium alloy such as $Li_ySn$, or a SnCu wire, lithiated in situ, which is inserted from the side to make contact with the separator. All such systems, which require extensive manual manipulations, are meant for laboratory use and are incompatible with commercial lithium- ion/polymer cell technologies.

A wire-type reference electrode is also shown in WO 2009/036444 A2. Alternatives disclosed in this document are a reference electrode having the shape of a pin, or use of the metallic casing as the reference electrode.

Inbuilt reference electrodes made of Li-Sn alloy in laboratory scale half-cells have shown that it is possible to measure the impedance over the anode-reference and cathode-reference loops independently, thus allowing, for example, the monitoring of the relative contributions of the anode and cathode towards the overall impedance of the battery [see D.P. Abraham, R. E. Reynolds, E. Sammann, A. N. Jansen, D. W. Dees, Electrochim. Acta 51 (2005) 502)]. The electrode was prepared in this case from a 25 $\mu$m diameter tin-coated copper wire which had been lithiated in situ, producing a $Li_{\sim4.4}Sn$ alloy which is described to display a relatively stable voltage at room temperature [D.P. Abraham, S.D. Poppen, A. N. Jansen, J. Liu, D. W. Dees, Electrochim. Acta 49 (2004) 4763-4775].

Two different variants of the above wire type reference electrode were tested upon manual incorporation into a small, lab-scale cell developed at Argonne National Lab: one sandwiched between the anode and cathode; the other placed slightly outside the separator where there is free electrolyte. Both configurations succeeded in measuring the impedance at the anode and cathode separately [see D. W. Dees, A. N. Jansen, D. P. Abrahams, J. Power Sources 174(2007)1001]. Furthermore, the two types yielded very similar results; thus favoring the external reference, which is often simpler to incorporate in a cell.

Although these cells have shown the value of determining the impedances at the anode and the cathode independently, the wire type reference electrode, which needs to be manually inserted, is not a practical solution for integrating a reference electrode into commercial lithium ion/polymer cells. The reasons for this stem from the physical nature of the wire electrode. It needs to be incorporated after the main components have been already assembled; it is difficult to place it correctly; the tiny wires tend to break or deform; and there is the danger that another structure of the cell, for example the separator, or the pouch or other casing, is penetrated, causing immediate cell failure or opening the door for the gradual cell degradation through processes such as the formation of dendrites which decrease cell capacity, and worse, might cause a short circuit. The same disadvantages result in using a pin as the reference electrode.

Another approach is shown in JP 2007-193986, namely use of a lithium foil, having a thickness of about 15 times that of the anode and the cathode active layer, and about 20 times that of the separator as a reference electrode, which is connected to a copper wire. The reference electrode may be placed at a distance to the positive electrode of about 1 mm. This approach is likewise not suitable for the integration of a reference electrode into a lithium foil battery by lamination of the components, because it would call for different fabrication processes.

The known, commercially available lithium-ion/polymer batteries usually consist of a 2-electrode configuration (anode and cathode). Independent determination of their key battery parameters including the voltage and the impedance over the cathode and the anode loops via a fully integrated reference electrode is not possible until now. Knowledge of the voltages of the anode and cathode should, however, increase the safety of the battery by providing information on when the anode and/or the cathode reaches unsafe voltages, which could, for example, lead to thermal runaway. Yet it is a fact that it is often necessary to drive the voltage of the anode and/or cathode very close to the safety limits, in order to obtain the maximum capacity out of a battery. However, in the absence of a reliable method to determine the individual voltages at the anode and cathode, some trade-offs between safety and capacity yield must be made.

It is the problem of the present invention to provide a means and methods which overcomes the disadvantages of the prior art and which enables determination of the voltage and the impedance over the cathode and the anode loops independently, without additional preparation steps during the fabrication of the batteries which have to be performed separately and outside the standard fabrication.

This problem is solved by providing an electrochemical cell based on lithium technology comprising the following components:

- a positive electrode containing a cathode material,
- a separator made of an electrically insulating material,
- a negative electrode containing an anode material,
  the electrodes and the separator having layer or sheet form,
- a liquid and/or solid ion conductor material for transportation of lithium ions between the positive and the negative electrode,

the said components being sealed within a casing (usually flat or wound up to a roll), wherein the positive and the negative electrode each comprise an electrically conducting structure extending through a wall of the casing for further electrical connection, characterized in that it further comprises:

- a reference electrode within the said casing which is electrically insulated from the positive and the negative electrode, the reference electrode having layer or sheet form comprising at least one non-metallic lithium compound , and an electrically conducting structure in layer or sheet form being in electrical contact with the said reference electrode, the electrically conducting structure extending through a wall of the casing for further electrical connection.

The term "based on lithium technology" shall be understood to include any kind of cell wherein the transport of the charges between the cathode and the anode balancing the intake or output of electrical current is provided via transport of lithium ions. The electrochemical cell can be a lithium battery, e.g. a primary type battery, but will in most cases be a lithium accumulator, i.e. a secondary type battery, comprising a positive electrode containing a cathode material, a separator made of an electrically insulating material, a negative electrode containing an anode material, and a liquid and/or solid ion conductor material for transportation of lithium ions between the positive and the negative electrode. This means that not only the "conventional" lithium batteries, accumulators and the like are comprised by the present invention, but also other closely related electrochemical cells which function on the principle of lithium ion transport. This is e.g. the case for systems which include rechargeable lithium-sulfur (Si-S) and Li-Air cells. These and comparable systems are regarded as systems "based on lithium technology" as described above, as well.

In many cases, the electrical conducting structure extending through a wall of the casing for further electrical connection will be a piece of metal or expanded metal, respectively,, but alternatively, it can e.g. be made from a respective electrode material, in case this material is selected such that leakage of liquid electrolyte is avoided (e.g. it is free of pores) or in case no liquid electrolyte is used within the cell. It usually has the form of a tab.

The cathode material is usually laminated to a cathode current collector, and likewise, the anode material is usually laminated to an anode current collector. These collectors often consist of a metal sheet or an expanded metal sheet. In these cases, the electrical conducting structure of the anode and of the cathode, extending through a wall of the casing, can be a piece of metal or expanded metal, preferably in sheet form, laminated to the respective current collector, or can be an integral part of the said current collector. The reference electrode may be provided in a comparable form, i.e. laminated or otherwise applied (e.g. coated) onto a current collector of an optionally expanded metal sheet which may be in direct electrical contact with the electrical conducting structure extending through a wall of the casing and possibly being integrally connected thereto (see also the below details).

Although not always necessary (e.g. if the electrode material has inherent binding properties as it may be the case for nanoparticulate materials), the cathode material and the anode material will usually be present in admixture with a binder which allows its provision in layer form, for example in sheet form, as known in the art. As a binder, usually an organic polymer is used, for example a fluorinated alkene. Polyvinylidene and its copolymers have been proven as specifically useful for the preparation of such electrodes. Likewise, the reference electrode material can be in admixture with such a binder. As well, the separator may have layer or sheet form, and may be electrochemically inert, or may include a solid polyelectrolyte material, such as $Li_{1.3}Al_{0.3}Ti_{1.7}(PO_4)_3$, $LiTaO_3 \cdot SrTiO_3$, $LiTi_2(PO_4)_3 \cdot LiO_2$, $LiH_2(PO_4)_3 \cdot Li_2O$, $Li_4SiO_4 \cdot Li_3PO_4$, $Li_9AlSiO_8$, $LiAlSi_2O_6$ (Spodumene), LiX + ROH, wherein X is Cl, Br, I (1, 2 or 4 ROH per LiX), or the like. Separators are known in solid and in gel form. Lithium ion transport may function, in some cases, via the solid/gelified electrolyte material within the separator only; in most cases, it will be supported or completely provided by the presence of a liquid electrolyte material, for example a lithium salt like lithium hexaflurophosphate or the like in a suitable solvent, for example in a plasticizer having formula $A^1$-D-$A^2$ wherein $A^1$ and $A^2$ are independently selected from $R^1$, $OR^1$ $SR^1$ or $NHR^1$ wherein $R^1$ means e.g. $C_1$- $C_6$ alkyl or $R^1$ and $R^2$ form together with D a hetero ring having five ring members, and wherein D can be C=O, S=O. C=NH or C=$CH_2$ or, in case it forms a hetero ring with $R^1$ and $R^2$, can additionally be selected from O, S, NH and $CH_2$. Oftenly used examples are ethylene carbonate, propylene carbonate, dimethyl carbonate, γ-butyrolactone, dioxolane, or dimethylsulfoxide.

The thickness of the cathode layer and the anode layer as well as that of the reference electrode layer can freely be selected; usually, it is in the range of about 80μm to 500 μm, more preferable of about 110 μm to 350 μm and most preferable of about 120 to 250 μm. However, for specific cases, e.g. for electrochemical cells intended for long lasting use (e.g. 15 to 20 years), it may be favorable to use layers of from more than 500 μm, e.g. 600 μm up to 1 mm or even more, in order to overcome the adversarial effect if a current will inadvertently be drawn through the reference electrode during voltage measurement. Although this current is of a very tiny amount (in the range of pico Amperes), it will often inevitably occur.

The current collector sheet can have a thickness of about 5 to 300 μm, preferably of about 100 to 200 μm, although thicknesses outside the mentioned ranges are possible.

The cell may be a single cell, including one electrode, one separator and one anode, or a bicell or multicell stack comprising more than one cathode and/or more than anode, for example arranged such that a first, flat current collector is in contact with respective electrodes on both of its flat sides, which each are in ion-conducting contact with a respective counter electrode. The said counter electrodes are laminated to their respective current collectors as well. If desired, these current collectors may again be in contact with a second electrode material which could be in ion-conducting contact with a further counter-electrode, and so on. The single cell or bi or multicell stack is usually packaged within a foil, pouch or other casing made of an insulating material, usually an organic polymer, in order to avoid leakage and contact with external moisture and other contaminants. Use of a laminated material for the pouch or other casing is possible; this material may include a metallic foil, if required or desired; however, a laminated of merely organic layers are preferred. Tabs or other contacts connected to the current collectors extend through a wall of the foil or other casing for further electrical connections.

Independent of whether the electrochemical cell based on lithium technology of the present invention is a single cell or a bi or multicell stack, it may contain one or, alternatively, two or more reference electrodes. If the cell comprises current collectors, one of the said reference electrodes can be placed on the or one cathode current collector and one other thereof can be placed on the or one anode current collector.

The description of the invention is accompanied by figures, wherein

Fig. 1          is a scheme highlighting possible voltage overshoots with potential safety hazards,
Fig. 2          outlines the battery management system involving the voltage measurements,
Fig. 3          outlines the battery management system surrounding,

| | |
|---|---|
| Fig. 4 | indicates A) the hypothetical voltage versus salt concentration profile of the desired reference electrode and B) salt concentration profiles across the anode, separator, and cathode of a representative li-ion cell during discharge. Time since beginning discharge is given in minutes (0 - 11.31 minutes) [B) adapted from J. Electrochem. Soc. 143 (1996) 1890], |
| Fig. 5 | indicates the diffusion layer thickness (distance) versus time plot for EC/DMC where $D_0$ = 3.00 x $10^{-8}$ $cm^2/s$., |
| Fig. 6 | indicates A) the top-side view of a full cell, B) the magnified view showing the diffusion gap, |
| Fig. 7 | shows the first 3 cyclic voltammograms of a $LiCoO_2$ cathode under experimental conditions of scan-rate 100 $\mu V/s$ and voltage versus $Li/Li^+$ reference, |
| Fig. 8 | depicts the linear sweep voltammogram of graphite anode under experimental conditions of scan-rate 10 $\mu V/s$ and voltage versus $Li/Li^+$ reference, |
| Fig. 9 | depicts the linear sweep voltammogram of $Li_4Ti_5O_{12}$ reference electrode under experimental conditions of scan-rate 10 $\mu V/s$ and voltage versus $Li/Li^+$ reference, |
| Figs. 10 to 13 | show specific designs of the inventive electrochemical cell construction, |
| Fig. 14 | is a comparison of the charge-discharge behavior of the different cells (A) standard lithium cell (B) embodiment as shown in Fig. 10, (C) embodiment as shown in Fig. 11 (see text for details), |
| Fig. 15 | indicates the simultaneous measurement of voltage between a) anode-cathode, b) cathode-reference, and c) anode-reference over the charge-discharge profile of 10 cycles with 1C between 3.0V and 4.2V followed by settling rest potential of 4.0 V. The anode, cathode, and reference electrode of this example contained graphite, $LiCoO_2$, and lithium titanate oxide, respectively, |
| Fig. 16 | is a diagram indicating impedance versus temperature measurement on an inventive three electrode cell with impedance spectra plotted as Nyquist plots for (A) anode - cathode loop and (B) anode - reference electrode. The anode, cathode, and reference electrode of this example contained graphite, $LiCoO_2$, and lithium titanate oxide, respectively, |
| Fig. 17 | is a diagram indicating an Arrhenius plot of Ln (Impedance) versus 1/temperature for the impedance measured at 100 mHz over the loops of a) anode-cathode, b) anode-reference and c) cathode-reference. The anode, cathode, and reference electrode of this example contained graphite, $LiCoO_2$, and lithium titanate oxide, respectively, |
| Fig. 18 | is a diagram of simultaneous measurement of voltage between a) anode-cathode, b) cathode-reference, and c) anode-reference over 0.2C charging and 1C, 2C, 4C, 6C discharge, The anode, cathode, and reference electrode contained graphite, $LiCoO_2$, and lithium titanate oxide, respectively. |
| Fig. 19 | is a diagram of simultaneous measurement of voltage between a) anode-cathode, b) cathode-reference, and c) anode-reference over 0.2C charging and 8C, 16C, 32C discharging with 3 discharges per each C-rate. The anode, cathode, and reference electrode of this example contained graphite, $LiCoO_2$, and lithium titanate oxide, respectively, |
| Fig. 20 | depicts a full cell voltage measurement during charge and discharge cycles (Fig. 20a) which is simultaneously tracked with the anode and cathode voltages against a LFP reference electrode (Fig. 20b) which allows clear discrimination of the different voltage contributions of the anode and cathode (Fig. 20c). The anode and cathode consist of graphite and $LiCoO_2$, respectively. (See examples for further details), |
| Fig. 21 | depicts charge and discharge cycles with pulse discharges with (a) and (b) showing the voltage between the anode and cathode ($\Delta V_{C-A}$) and Figure 21 (c) and (d) showing the voltages at the anode ($\Delta V_{R-A}$) and cathode ($\Delta V_{C-R}$) as measured against the reference electrode. All charging events were done at 0.2 C CC-CV and the discharges over the range of 1- 30 C where i) is 1 C, ii) 2C, iii) 5C, iV) 10C, v) 20C and vi) 30C. Each pulse was 18 seconds long and was followed by a 60 second open-circuit rest period before the next pulse. The anode, cathode, and the reference electrodes consist of graphite, $LiCoO_2$, and LTO, respectively. (See examples for further details), |
| Fig. 22 | depicts charge and discharge cycles with pulse charges of i) 1C, ii) 2C, iii) 3C, and iv) 5C with each pulse being 18 seconds long followed by a 60 second open-circuit rest period before the next pulse. The anode, cathode, and the reference electrodes consist of graphite, $LiCoO_2$, and LTO, respectively (see examples for further details). |
| Fig. 23 | indicates the voltage versus capacity of lithium ion (salt) intake profiles for several chemical electrode materials useful in the present invention. |

In order to overcome the drawbacks of the prior art, the inventors of the present invention came to the conclusion that a reliable internal reference electrode for measurement of voltage and impedance within a closed cell should have the following properties:

- A voltage drift as minimal as possible
- Chemical compatibility with lithium technology
- Robust electrode system without aging effects.

The electrochemical cell of the present invention is characterized in that it comprises a reference electrode comprising or made of at least one non-metallic lithium compound. In all embodiments of the invention, this compound is preferably selected under $Li_4Ti_5O_{12}$, $LiFePO_4$, $Li(Ni_{0.5}Mn_{1.5})O_4$, $LiCoO_2$, $LiMn_2O_4$, $LiNiO_2$, $LiNi_{0.8}Co_{0.15}Al_{0.05}O_2$ (NCA), $LiCo_{1/3}Ni_{1/3}Mn_{1/3}O_2$ (NMC), $Li_2FePO_4F$, $Li(Li_aNi_xMn_yCo_z)O_2$, Graphite ($LiC_6$), disordered carbon (hard and soft carbons), $Si(Li_{4.4}Si)$, and $Ge(Li_{4.4}Ge)$. Those compounds in which lithium is present in zerovalent (not positively charged) condition can be introduced into the cell in a precursor state without lithium. As soon as the cell is cycled for the first time, lithium atoms will be incorporated therein, resulting in the lithium containing compound.

Under the materials mentioned above, $Li_4Ti_5O_{12}$, $LiFePO_4$, and $Li(Ni_{0.5}Mn_{1.5})O_4$, are more preferred, and $Li_4Ti_5O_{12}$ and $LiFePO_4$ are most preferred.

This finding is based on the following considerations: The above mentioned compounds meet the requirements of compatibility with lithium technology in batteries and accumulators. In contrast to metal or alloy materials, they are usually present in the form of a powder, which can be combined or incorporated into an organic polymer, thus opening the possibility to use the same production methodology and the same consistency or chemical composition of the organic components present in the cathode, the anode, and the reference electrode. Ideal candidates for the reference electrode will be those known for their exceptional stability in lithium ion/polymer cells (e.g., $LiFePO_4$, $Li_4Ti_5O_{12}$), and therefore, they are specifically preferred. However, considering that a reference electrode acts as a potentiometric sensor (i.e., remains under equilibrium conditions), which by definition passes no significant current, the aging phenomena associated with active anode or cathode materials (e.g., aging due to continuous cycles of expansion and contraction) are absent at the reference electrode. Therefore, the choice of materials may be extended to all other materials compatible with lithium ion technology and mainly to those mentioned above.

The voltage drift of a reference electrode arises from instabilities in the redox reaction governing the reference electrode chemistry. As an example, in the classic Ag/AgCl reference electrode ($AgCl + 2e^- \leftrightarrow Ag + Cl^-$), the potential (E) is determined by the Nernst equation:

$$E = E^{0'} + \frac{RT}{nF} \ln \frac{1}{\left[ Cl^- \right]}$$

*where,*

*$E^{0'}$ = formal potential; R = mol a r gas cons tan t; F = Faraday cons tan t;*
*n = number electron s in volved in redox reaction; T = temperature;*
*[Cl⁻] = concentration of Cl -*

Over time, the loss of $Cl^-$ from a standard Ag/AgCl reference electrode and the accompanying decrease in chloride ion concentration causes a voltage drift. Similarly, any drift in temperature would also lead to a voltage shift.

In a first embodiment of the invention, such a voltage drift is prevented by using an electrode with a flat voltage versus lithium-ion concentration profile.

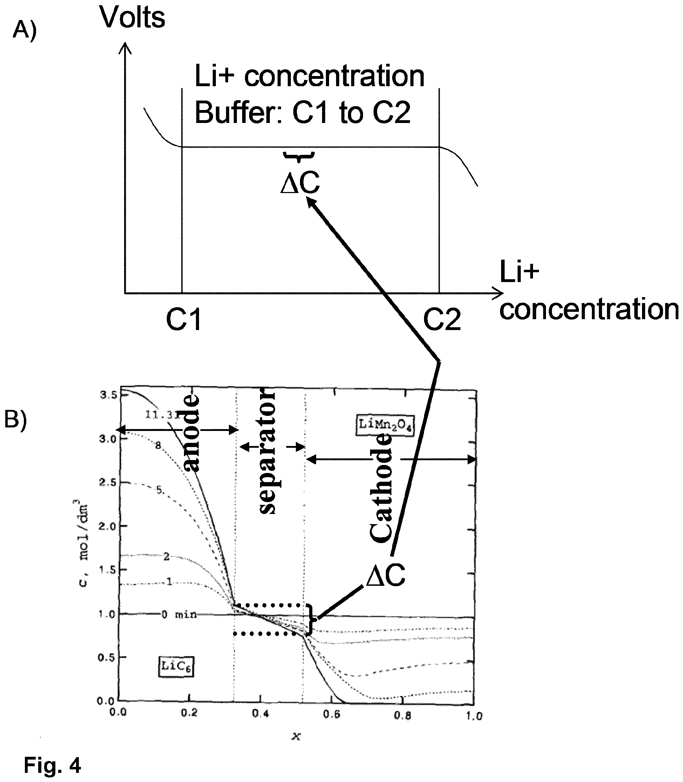

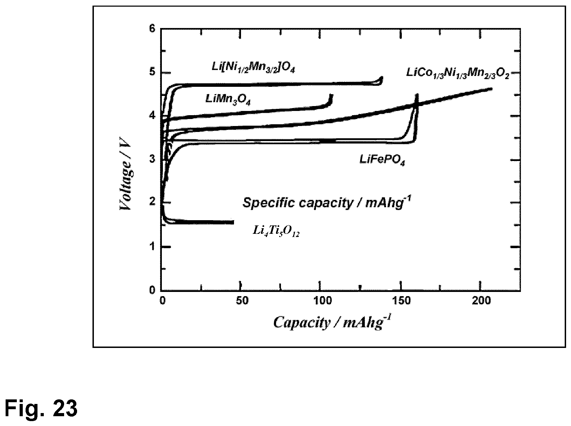

In this type of the reference electrodes described here, the reference electrode chemistry is chosen such that it is sensitive to $Li^+$ but holds a nearly constant voltage over the entire range of $Li^+$ concentrations the electrode encounters **(Fig. 4).** Such a reference electrode may be placed anywhere in the separator, as far as it is electrically insulated against the other electrodes. Furthermore, such an electrode can be miniaturized as its function is governed by potentiometric principles (i.e., negligible current flow). The relatively minor changes in the $Li^+$ concentration within the separator, which is in sharp contrast to that within the electrodes, also prevents any significant build-up or depletion of $Li^+$ in the separator (J. Electrochem. Soc. 143 (1996) 1890). Several candidate electrochemical systems meet the above criterion (see Figure 23). In particular, the systems especially suitable for lithium-ion/polymer cells are those which also meet the other standards (chemical compatibility, no aging, etc.) such as $LiFePO_4$, $Li_4Ti_5O_{12}$.

Over very extended periods of usage, it is possible that even the extremely small currents drawn for making the voltage measurements could drive the reference electrode to complete lithiation or de-lithiation where a significant change in the voltage could take place. This can be avoided by periodic passing of small currents between the reference electrode and the anode or the cathode or any other electrode to bring the state of the reference electrode to one where it is well within the flat voltage window.

With proper cell design, the choice of materials for the reference electrode can be extended to even those without a flat voltage curve. In these cases, cell geometries with effective diffusion barriers shall be selected. This second embodiment can be used alternatively or in addition with the conditions of the first one.

The theoretical basis rests with diffusion characteristics within the separator. Fick's second law describes how diffusion causes the concentration field to change with time:

$$\frac{\partial C_0(x,t)}{\partial t} = D_0 \frac{\partial^2 C_0(x,t)}{\partial x^2}$$

This equation can be solved for a discrete step change in concentration from an initial homogenous concentration (C*) to another concentration at position x=0. Often, this equation is solved under the following boundary conditions where the concentration at x=0 ($C_0$) is taken to equal that in the bulk (C*) initially (t = 0) and zero at other times

$$C_0(x,t) = C_0^* \, (for \; t = 0)$$

$$\lim_{x \to \infty} C_0(x,t) = C_0^*$$

$$C_0(0,t) = 0 \, (for \; t > 0)$$

The solution to the Fick's second law is then given by the following equation where $D_0$ is the diffusion coefficient of the species.

$$C_0(x,t) = C_0^* erf\left[\frac{x}{2(D_0 t)^{1/2}}\right]$$

This equation describes that the zone near x = 0 where the concentrations differs from those of the bulk (which is commonly referred to as the diffusion layer) does not have a finite thickness, but reaches bulk concentration values asymptotically (see Angew. Chem. Int. Ed. Engl. 32 (1993) 1268). However, it is common to approximate the diffusion layer thickness in terms of $(D_0 t)^{1/2}$, which has units of length and characterize the distance that the species can diffuse in time $t$ (See: A. J. Bard, L. R. Faulkner, "Electrochemical Methods: Fundamentals and Applications," 2nd ed., John Wiley & Sons, New York, 2000.) An often used equation to calculate the diffusion layer thickness is the following:

Diffusion layer thickness ($\gamma$) = $2(D_s t)^{1/2}$

Here, the notation $D_s$ is used instead of $D_0$ merely to indicate the more solid nature of separator in lithium polymer cells (gels, ceramics, etc.)

**Table 2** gives the values for $D_s$ and transference numbers for several typical electrolytes used in lithium-ion cells.

**Table 2**

| Electrolyte | Ds at 25°C (cm²/s) | t+ |
|---|---|---|
| EC/DMC | $3.001 * 10^{-8}$ | 0.598 |
| EC/EMC | $5.306 * 10^{-8}$ | 0.671 |
| EC/DEC | $3.834 * 10^{-8}$ | 0.441 |

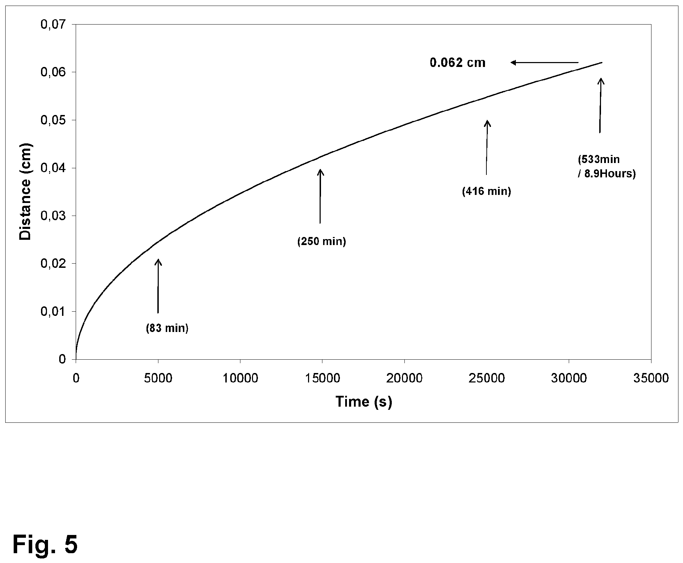

**Fig. 5** illustrates the distance versus time profile for EC/DMC. As seen, the very low value of $D_s$ (2 - 3 orders of magnitude lower than for some aqueous species) means that the diffusion layer grows extremely slowly. For example, even at ca. 9 hours, the layer grows to only about 600 $\mu$m. This implies that if the reference electrode is placed a short distance from the anode and the cathode, it would not be sensitive to any fluctuations in the salt concentration in the separator region between the anode and the cathode.

A reasonable range for the diffusion distance can be arrived at by considering the range of charge/discharge rates (C-rates) associated with lithium batteries (C is the charging/discharging rate, defined as follows: 1C means a complete charge or discharge within 1 hour. The factor 1, 2 or the like C means that complete charging/discharging is performed within a time which is 1h divided through said factor, i.e. 2C means half an hour and 100C means 1/100 of an hour). For nearly all applications, the charging is done at rates no slower than 0.1C with more common rates falling within 1C and 10C. The same holds true for discharge except the high discharge rates could extend up to about 30C.

The following table summarizes the diffusion distances associated with different C-rates. The distance is calculated according to the standard diffusion distance equation: distance = $2(Dt)^{1/2}$. Typical organic solvents for lithium batteries have a D in the order of $1 \times 10^{-8}$ $cm^2/s$.

| Charge/Discharge Rate (C-Rate) | -Charge/Discharge Time (seconds) | Diffusion distance / mm |
| --- | --- | --- |
| 100 C | 36 | 0.02 |
| 30 C | 120 | 0.04 |
| 20 C | 180 | 0.05 |
| 10C | 360 | 0.07 |
| 1 C | 3600 | 0.21 |
| 0.1 C | 36000 | 0.66 |
| 0.01 C | 360000 | 2.08 |

Therefore, during normal battery usage (1C to 30C) it is unlikely that the lithium concentration changes in the separator region beyond 1 mm from the perimeter of the anode and cathode. Taking this into account, the distance between the boundaries of the reference electrode and those of the adjacent electrode should be in this embodiment at least 0.3 mm, preferably at least 0.7 mm, more preferably at least or larger than 1 mm, even more preferably at least 1.5 mm, even more preferably at least 2.1 mm and most preferably at least 2.8 mm.

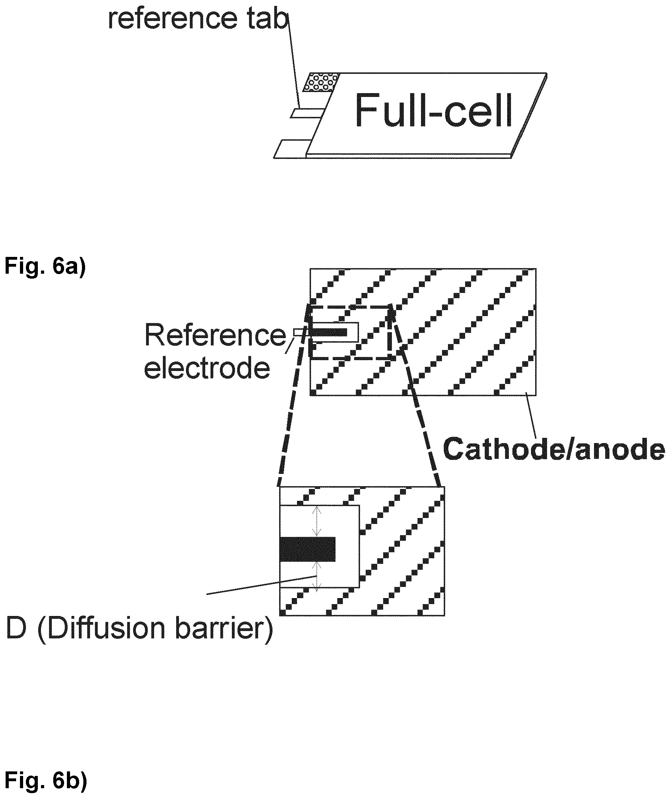

Fig. 6 shows how such a diffusion barrier can be implemented in a full cell. Here, the gap on the lateral plane (x-y direction) of the reference electrode is shown, but a similar gap is allowed in the vertical plane (x-z or y-z) as well.

Selecting a proper diffusion barrier as outlined above results in masking the reference electrode from possible voltage drifts caused by fluxes of $Li^+$ ions.

Selecting a suitable cell geometry may further aid minimization of the voltage drift in that effective gaps for heat dissipation are provided:

The Fick's law governs the diffusion of heat through a medium in the same manner it does the diffusion of chemical species. Therefore, the same arguments as above could be made for the use of an effective gap for the dissipation of heat. In a battery, heat is generated at the anode and/or cathode during charge and/or discharge. The amount of heat depends on the charge and/or discharge rate. The reference electrode potential (as seen in the Nernst equation above) can be sensitive to this if it is placed very close to the anode and/or cathode. In this invention described, the reference electrode is surrounded by a separator through which the heat generated at the anode and/or cathode can dissipate. Therefore, the distance of heat transfer versus time plot would have a similar shape as that in Fig. 6 governed by the heat diffusivity within the separator. However, heat dissipation can be expected to be drastically reduced when the heat can also escape perpendicularly from the separator to the surrounding air as possible in some designs. These effects are exploited in rendering the reference electrode insensitive to any temperature fluctuations.

Selecting a proper gap for heat dissipation provides masking of the reference electrode from possible voltage drifts caused by fluxes of $Li^+$ ions and/or due to temperature fluctuations.

According to the present invention, the reference electrode has manufacturing compatibility with standard lithium-ion/polymer processes (lithium batteries or accumulators in sheet form). In most cases, these processes involve preparation of a pasty mass made of the respective electrode material and a binder (in most cases an organic polymer), optionally in admixture with a plasticizer and/or with a solvent having high volatility and/or with a conductivity enhancer, e.g. a carbon material having a high surface, as carbon black or graphite. The pasty mass is brought into film form and dried or cured, to provide an electrode film. The separator can be made accordingly, except that no electrode material may be incorporated, but possibly a solid electrolyte material. Alternatively, the separator can be made of a gel-like organic polyelectrolyte.

Except the case that the electrical conducting structure extending through a wall of the casing for further electrical connection of the reference electrode is made of the material of the reference electrode, as outlined above, it will usually be a metallic foil or sheet. Further, a metallic foil or sheet may act as a current collector of the reference electrode. In these cases, it is usually covered with reference electrode material, e.g. by lamination or coating. In specifically preferred cases, the electrical conducting structure extending through a wall of the casing and the current collector are made integral, for example are one piece of metal or expanded metal.

That part thereof which extends inside the electrochemical cell is then at least partly covered with reference electrode material. In preferred embodiments, the metallic foil or sheet is made of copper (specifically preferred for lithium titanate) or aluminum (specifically preferred for LiFePO$_4$).

In a specific embodiment of the invention, the metallic foil or sheet is covered with a layer of the reference electrode material on both sides, preferably by coating or lamination. This is specifically advantageous if the electrode material comprises some binder, as it is usually the case. The double-sided coating allows a stronger binding to the top and bottom separator in embodiments where the reference electrode is sandwiched between two separators. In these embodiments, a reference electrode applied to only one side of the current collector would result in the danger that the uncoated side would either have a poor contact to the separator or would become separated over the time. Both scenarios would compromise the performance (e.g. would cause electrical short-cuts) and/or the physical integrity of the cell (e.g. ripping off of the separator).

The electrical conducting structure extending through a wall of the casing for further electrical connection of the reference electrode has usually the shape of a tab which extends through the package or casing of the electrochemical cell, like it is usually the case with the current collectors of the anode and the cathode.

In a preferred embodiment of the invention, the reference electrode is electrically insulated from the negative electrode and from the positive electrode via the separator material and/or via an electrically insulating coating provided on the reference electrode and/or on one of the electrodes. Such an embodiment can for example be realized by providing at least two separator layers in vicinity to each other and the only or more than one reference electrode(s) is/are placed between two of the said separator layers.

If the electrodes and the separator have layer form, they usually have their larger extensions in x-y direction, for example in a cm range, compared with their thickness (extension is z-direction) which is usually much lower. The cell geometry is freely selectable, the area of each layer of the electrode or separator in common applications being selected in most cases between around 0,25 cm$^2$ up to 100 cm$^2$ or even more (e.g. $\geq$1 m$^2$), for example in cases where the cell will be used in rolled form. The thickness can be in the range of between 10 and 1000 $\mu$m and preferably between 70 and 300 $\mu$m. Although their shape is freely selectable, the cells are often flat or have been rolled up to a cylinder, so that the single electrode and separator layers can have a length and/or width in the range of 1 mm to more than one meter or even more.

There are different possibilities of configuration of the electrochemical cell of the present invention in order to meet the requirements of the second embodiment (minimum distance between the boundaries of the reference electrode and those of cathode and anode). Some variants of them can be described as indicated below; specific designs thereof are depicted in the accompanying figures:

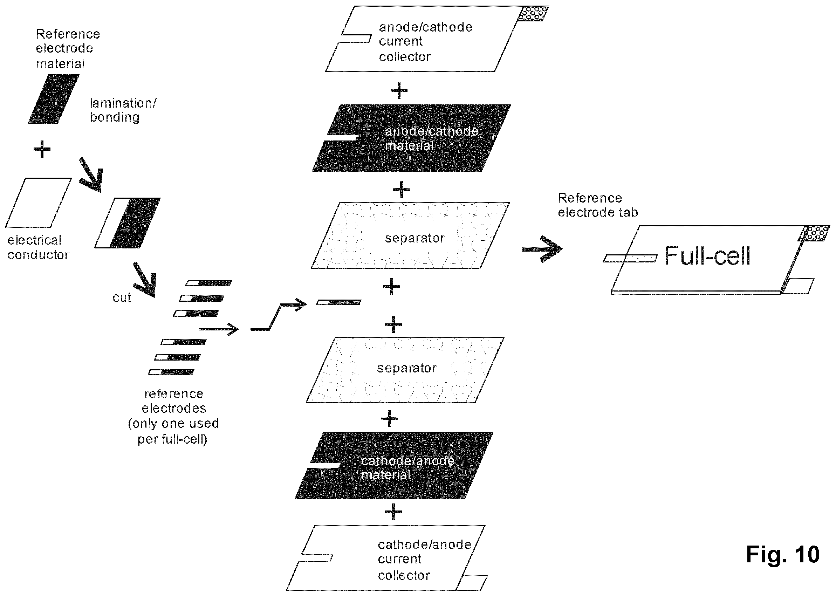

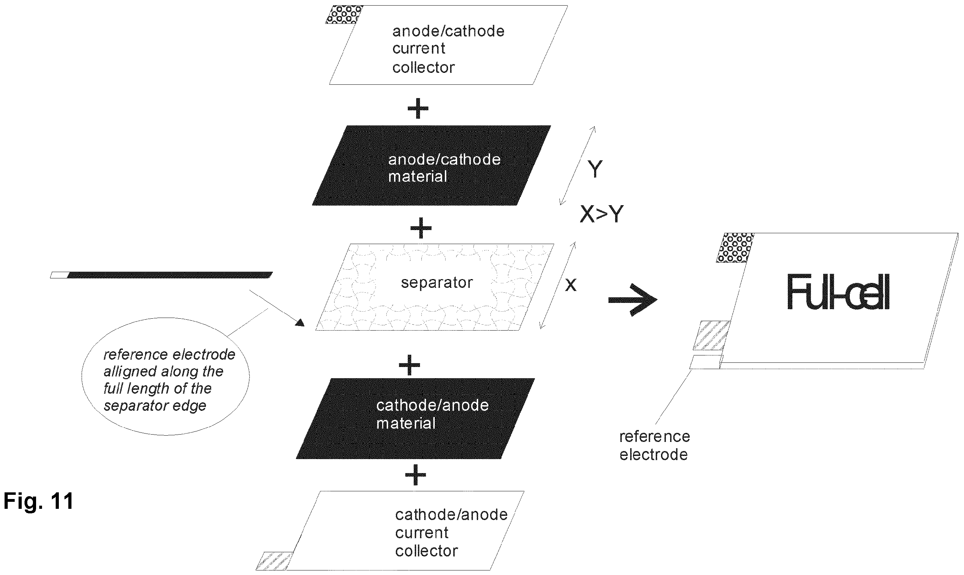

(a) The reference electrode is placed outside the area of the positive electrode and/or the negative electrode (the area being defined as a layer in x-y direction, i.e. the term "outside" is used when the cell is looked at from above, in z-direction), see e.g. Fig. 10 and 11.

(b) The structure as mentioned in (a) can further be designed such that the length or the width of the separator layer is larger than that of the electrode layers and the layers are placed one on top the other such that the separator layer projects from the electrode layers on one side of the battery, characterized in that the reference electrode is attached to the separator layer along its projecting length, see Fig. 11.

(c) Alternatively, the structure as mentioned in (a) can further be designed such that at least one of the electrodes has a recess or notch cut out of the layer, and the reference electrode, seen in z-direction, is placed in the area of the said notch or recess of one of the electrodes. In these cases, it is preferred that two separator layers are present and that the reference electrode is placed between the said separator layers, see Fig. 10. Placement of the reference electrode outside the planes of the cathode and the anode avoids electrical field effects arising from the anode and/or cathode which may disturb the reference potential. Further, within the separator, the least fluctuations in Li$^+$ concentration take place.

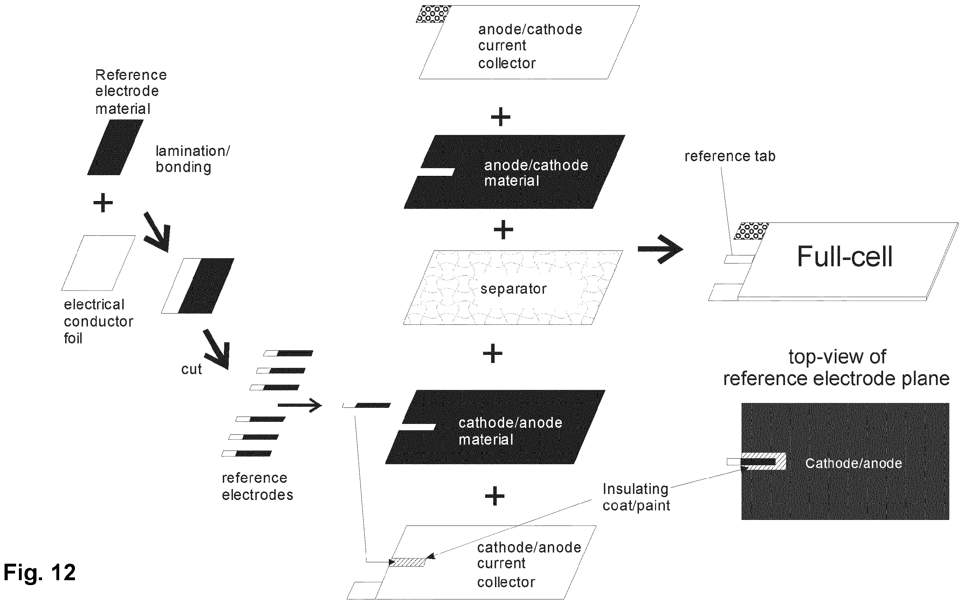

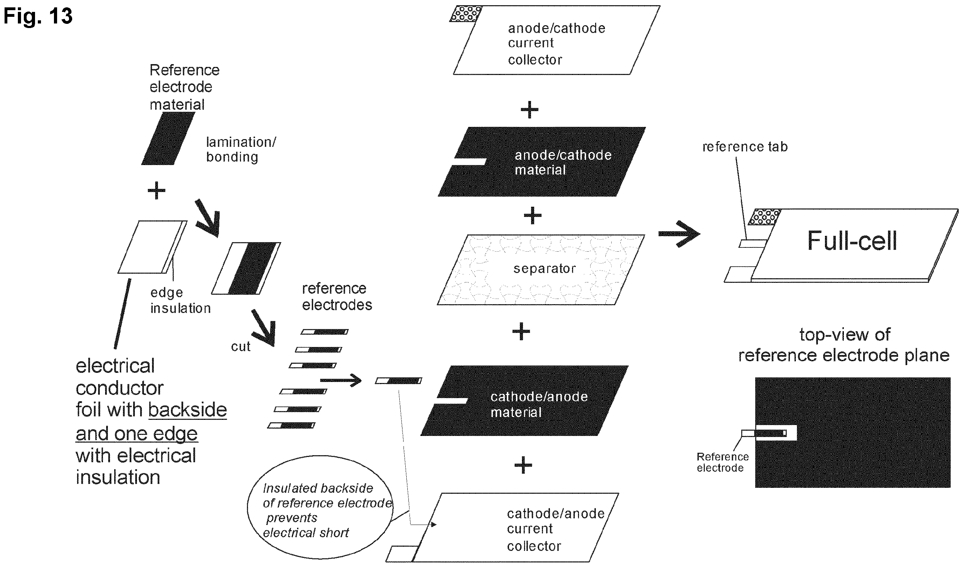

(d) The reference electrode can be placed on one of the cathode current collector and the anode current collector, separated therefrom by an insulating material, such that it is situated within the recess or notch of the adjacent electrode, see Figs. 12 or 13. The insulating material can be provided as an insulating coat or paint situated on the respective cathode or anode current collector, see Fig. 12, and/or on the side of the reference electrode or its electrical conductor foil which faces the respective current collector, see Fig. 13. The gap between the reference electrode and the adjacent electrode within the level or plane of said electrode should in these cases also be filled with insulating material. Alternatively, this gap can be filled with material from the adjacent separator, which is pressed into it during lamination and sealing of the cell.

(e) In specific embodiments of the invention, the electrochemical cell based on lithium technology may contain two or more reference electrodes. These can be electrically connected inside or outside the cell, or they can be situated electrically separated from each other, for example in order to provide separate measurements of aging phenomena of the cathode and the anode. They may be made of the same material, e.g. from one of $Li_4Ti_5O_{12}$ or $LiFePO_4$, or of different materials, e.g. one of $Li_4Ti_5O_{12}$ and the other of $LiFePO_4$.

(f) In specific variants of embodiments according to the preceding item (e), one of the reference electrode is placed on the cathode current collector and the other or one other thereof is placed on the anode current collector.

Masking of the reference electrode, if desired, can optionally be performed by placing it outside the flux of Li-ions, e.g in the separator region slightly laterally away from the space between the anode and cathode, seen from the top or bottom along the Z-axis (in z-direction), or in the plane of an electrode or current collector, outside the anode/separator/cathode sandwich, e.g. within a recess or notch of the electrode or current collector, or being situated with the necessary distance to and along an x or y boundary thereof.

In general, the electrochemical cells based on lithium technology according to the present invention can be prepared using the same and comparable steps, relative to known electrochemical lithium cells. Preferably, the cells are prepared using the following steps:

a) Preparation of the anode, cathode, and reference electrode
b) Layering of all required materials one on top the other (i.e., laminating current collectors, anode and cathode materials, and polymeric separator together)
c) Connecting tabs to the electrodes and enclosing everything in a foil pouch
d) Filling liquid electrolyte (if necessary) and sealing the pouch under inert, water-vapor-free atmosphere.

A reference electrode in a lithium polymer battery would enable the following benefits:
**Simultaneous monitoring of the voltage of the anode and cathode:** State-of-the-art (SOA) lithium-ion/polymer batteries consist of a 2-electrode configuration (anode and cathode). The integration of a fully functional internal reference electrode would allow the determination of the voltage over the cathode and the anode loops independently. Furthermore, knowledge of the anode and cathode voltages enables the calculation of the full cell voltages which is the sum of the anode and cathode voltages against the reference electrode. Alternatively, by the same mathematical relationship, if the full cell voltage is measured and only one of the cathode and anode voltages is measured, then the other can be calculated.

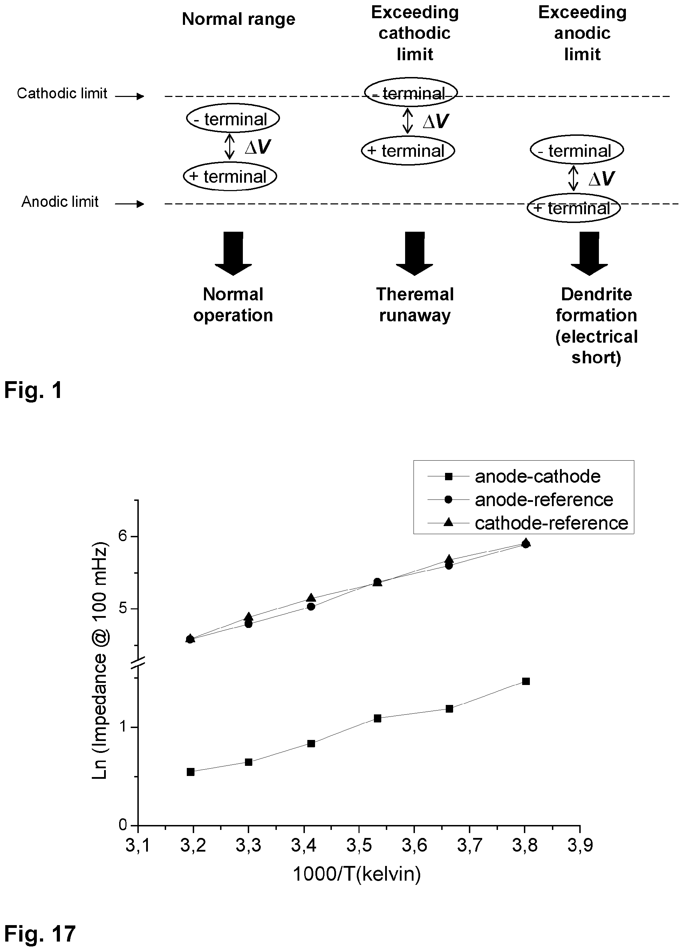

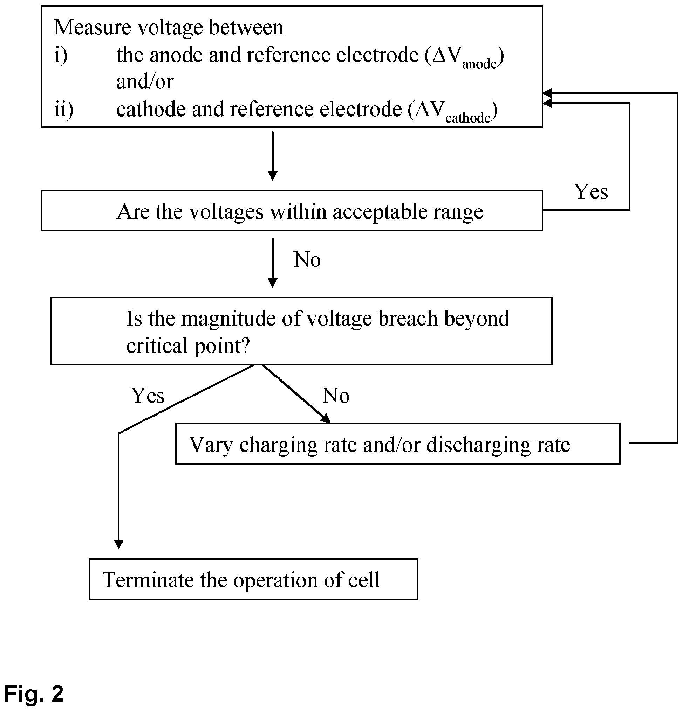

**Enhanced safety of use:** Knowledge of the voltages of the anode and cathode can increase the safety of the battery by providing information on when the anode and/or the cathode reaches unsafe voltages. For example, in this manner, common problems plaguing lithium batteries such as the formation of lithium dendrites on the anode and the onset of dangerous oxidation processes at the cathode may be avoided. In a 2-electrode system, where only the voltage difference between the anode and cathode ($\Delta V$) is known, a normal $\Delta V$ may mask the breach of the safe potential limit as shown in **Fig. 1.** In a system with a reference electrode, a battery management system can be used to deactivate or alter the operation of the battery whenever unsafe voltages are registered. The battery management system would have the basic properties (but not limited to) those outlined in **Fig. 2.** Added features and options to the management system can include the selection of the frequency of voltage measurements (e.g., continuous or periodic with varying time intervals), storage of measured data for tracking battery history, etc.

**Optimal use of battery:**

(A) **Energy density:** To obtain the maximum capacity out of a battery, it is often necessary to drive the voltage of the anode and/or cathode very close to the safety limits. However, in the absence of a reliable method to determine the individual voltages at the anode and cathode, some trade-offs between safety and capacity yield must be made (i.e., the battery remains with an offset voltage buffer at both charge and discharge ends). For example, the situation with a graphite anode highlights such a trade-off. During charging of graphite, the capacity stored over the voltage drop down to 0,1 V (vs. $Li/Li^+$) is ~100 mAh/g whereas more than 300 mAh/g capacity is stored between 0,1 and slightly above 0 V (H. Nozaki et al., J. Power Sources 194 (2009) 486-493). A reliable control of the voltage, as provided by a reference electrode, would enable optimum use of this capacity (i.e., without risking dendrite growth or electrolyte oxidation).

(B) **Power density:** At high charge and/or discharge rates, the chances of overshooting the voltage limits are increased. An inbuilt reference electrode can alleviate this problem in a manner similar to that described in (A) above.

(C) **Longer battery life:** Too high or too low voltages on the anode and/or cathode can shorten the battery life due to multiple reasons including deleterious film formations which cause capacity fading, lithium deposition on the anode, electrolyte degradation, electrode material dissolution, and undesirable chemical reactions involving trace impurities (e.g., reactions involving $H_2O$ leading to HF formation). Tracking the anode and/or cathode voltage allows the battery to avoid such situations in a manner similar to that described in "Enhanced safety of use" above.

**Simultaneous monitoring of the impedance on the anode and cathode loops:** Inbuilt reference electrodes in laboratory scale half-cells have shown that it is possible to measure the impedance over the anode-reference and cathode-reference loops independently, thus allowing, for example, the monitoring of the relative contributions of the anode and cathode towards the overall impedance of the battery. D.P. Abraham, R. E. Reynolds, E. Sammann, A. N. Jansen, D. W. Dees, Electrochim. Acta 51 (2005) 502). In this manner, it would be possible to determine the aging properties of the anode and cathode independently. The degradation of the current collectors (e.g., due to corrosion, film formation) will also be reflected in a rise in impedance. In principle, impedance data from different frequency regimes can provide additional information such as the rate of charge transfer, double layer capacitance, conductivity and diffusion coefficients, etc., based on well known principles of electrochemical impedance spectroscopy (IES). (S-M. Park and J-K Yoo, Anal. Chem., 75 (2003) 455 A.)

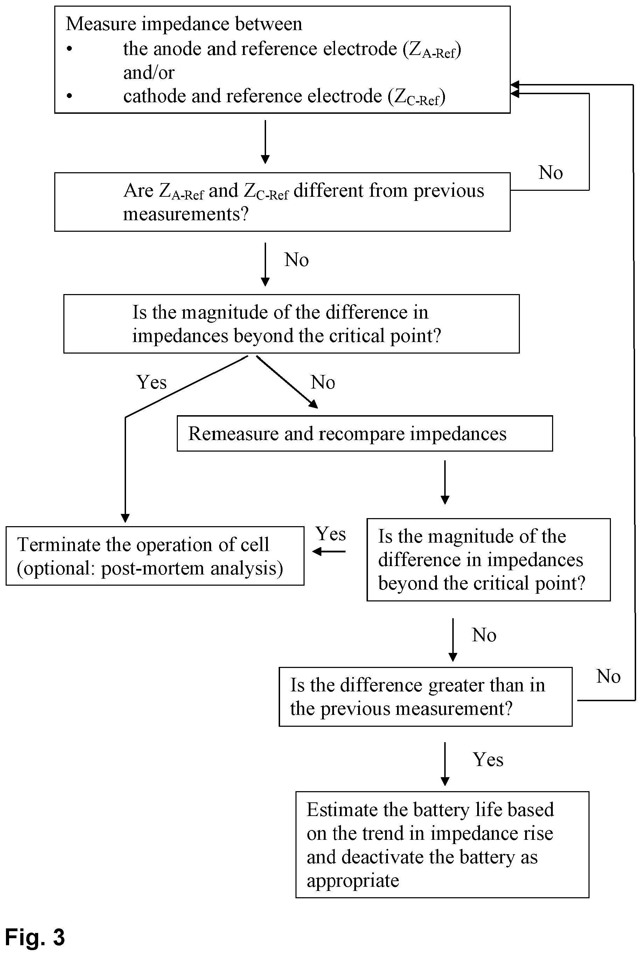

Apart from monitoring the above diagnostic parameters which evolve gradually with time, impedance measurements along both the anode and cathode circuits could be helpful in diagnosing imminent battery failure (e.g., film formation from rapid electrolyte degradation, loss of SEI protection, disintegrating electrical contacts, etc.). This would be indicated by a rapid rise in either the impedance of the anode and/or cathode circuits. Such information may not be readily available from a 2-electrode system. This is because the impedance is known to change with the amount of lithium in the electrode materials, so opposing trends in the anode and cathode weaken the diagnostic value of the impedance measured in such a system. Moreover, the independent information of the evolution of the anode and cathode impedances can provide useful information for identifying which of the two is most vulnerable to aging, thus aiding in the design of better batteries. The impedance measurements can be part of a battery management system where key decisions such as when to discontinue the battery can be made **(Fig. 3).**

**State-of-charge (SOC) measurement:**

The SOC for lithium ion/polymer cells is defined as the available capacity with respect to a percentage of some reference capacities. Often, this reference capacity is a fully charge cell, so a 100% SOC means a fully charged cell while a 0% SOC means a fully discharged cell.

One key state-of-the-art means of measuring SOC takes into account the relationship between the cell voltage (between anode and cathode) and charge level of a cell. Indeed, this is extremely useful in the case of lead-acid batteries where there is a linear relationship between the voltage and level of charge. The same holds true for lithium ion/polymer cells when the voltage of the anode and/or cathode changes with SOC. Once such a calibration curve has been established, the SOC can be estimated from the measured voltage.

However, there is a well recognized source of error with the above way of measuring SOC which is associated with hysteresis in that the SOC estimated from the voltage is affected by the history discharge or charge history. In full cell measurements, any hysteresis of the anode and cathode are added, so the SOC derived from the voltage measurement has errors contributing from both the cathode and the anode.

An alternative way to determine the SOC is to relate it to the voltage of the cathode or the anode to the SOC. This is only possible when a reference electrode is present and the anode or cathode voltage is measureable. By measuring the SOC in this way, only the hysteresis of the anode or cathode contributes to the measurement error. In practice, the same steps as described above in deriving the SOC from the full cell voltage would be followed except the voltage is concerned (and the calibration curve) with the anode or cathode voltage

Consequently, the present invention further comprises a method for measuring the voltage of a cathode and/or of an anode of an electrochemical cell based on lithium technology, wherein the cell includes the following components:

- a positive electrode containing a cathode material,
- a separator made of an electrically insulating material,
- a negative electrode containing an anode material,
  the electrodes and the separator having layer or sheet form,
- a liquid and/or solid ion conductor material for transportation of lithium ions between the positive and the negative electrode,
- a reference electrode in layer or sheet form which is electrically insulated from the cathode and the anode, comprising at least one non-metallic lithium compound and being in electrical contact with an electrically conducting structure in layer or sheet form ,

the said components being sealed within a casing, wherein the positive electrode and the negative electrode each comprise an electrically conducting structure which, as well as the electrically conducting structure being in electrical contact with the reference electrode, extend through a wall of the casing for further electrical connection, the method including the following steps:

(a) charging and/or discharging the cell once or more times,
(b) measuring the voltage between the cathode and the reference electrode and/or between the anode and the reference electrode once or more times, and subsequently
(c) settling the rest potential to a desired value between the charge and discharge value.

In this method, the voltage of a cathode and of an anode of the said electrochemical cell based on lithium technology can be measured simultaneously by measuring the voltage between the cathode and the reference electrode and between the anode and the reference electrode simultaneously.

In a further embodiment of this invention, in the said method, the anode and/or cathode voltage is measured by measuring the voltage between the cathode and the reference electrode or the voltage between the anode and the reference electrode, and a state-of-charge (SOC) of the cell is derived therefrom, using a pre-determined or in situ calibration curve relating the SOC of the cell to the anode or cathode voltage.

In all these embodiments, the voltage between the cathode and the anode can be measured in addition, in order to prove whether the equation

$$\Delta V_{C-A} = \Delta V_{C-Ref} + \Delta V_{A-Ref}$$

wherein C is the cathode, A is the anode, and Ref is the reference electrode, is fulfilled.

Further, in all these embodiments, the charging and/or the discharging of the cells is made once or more than once or twice and the charging and the discharging is either made at constant C rates or at or at varying rates.

In a specific embodiment, more than one measurement of voltage is performed and between two of such measurements, a small current is passed between the reference electrode and the cathode or the anode, to bring the state of the reference electrode to one where it is well within a flat voltage window.

Further, the present invention comprises a method for measuring impedance of a cathode and of an anode of an electrochemical cell based on lithium technology independently, characterized in that the cell includes the following components:

- a positive electrode containing a cathode material,
- a separator made of an electrically insulating material,
- a negative electrode containing an anode material,
  the electrodes and the separator having layer or sheet form,
- a liquid and/or solid ion conductor material for transportation of lithium ions between the positive and the negative electrode,
- a reference electrode in layer or sheet form which is electrically insulated from the cathode and the anode, comprising at least one non-metallic lithium compound and being in electrical contact with an electrically conducting structure in layer or sheet form ,

the said components being sealed within a casing, wherein the positive electrode and the negative electrode each comprise an electrically conducting structure which, as well as the electrically conducting structure being in electrical contact with the reference electrode, extend through a wall of the casing for further electrical connection, the method including the following steps:

(a) applying a constant voltage between the cathode and the anode
(b) measuring the impedance across least one of the $Z_{C-Ref}$ and $Z_{A-Ref}$ loops, wherein C is the cathode, A is the anode, and Ref is the reference electrode.

In this method, it is possible that the result from measuring the impedance is used for an assessment of aging of at least one of the electrodes, including the additional steps:

(c) assessing whether the said impedances are within an acceptable range

- if no, terminating the cell;
- if yes, re-measuring the impedance and repeating the loop,and either

(d) logging the impedance rise of the anode and cathode to estimate the aging of each and thereby estimating the life-time of the cell,and/or
(e) estimating the power capability losses at the anode and/or cathode by associated impedances.

The present invention further provides a method for managing an electrochemical cell based on lithium technology, comprising the following steps:

- providing an electrochemical cell based on lithium technology according to the present invention,
- measuring the voltage between

    (i) the anode and the reference electrode ($\Delta V_{anode}$) and/or
    (ii) the cathode and the reference electrode ($\Delta V_{cathode}$),

- checking whether the said voltages are within an acceptable range, and
- either, if yes, measuring the said voltages again, if required,
- or, if no, checking whether the magnitude of voltage breach is beyond a critical point, and

    - if yes, terminating the operation of the cell, or
    - if no, varying the charging rate and/or discharging rate and subsequently measuring the said voltages again, if required.

In addition, the present invention provides a method for managing the optimal use of a battery, comprising the following steps:

- providing an electrochemical cell based on lithium technology according to the present invention,
- measuring the voltage between

    (i) the anode and the reference electrode ($\Delta V_{anode}$) and
    (ii) the cathode and the reference electrode ($\Delta V_{cathode}$),

- determining the individual voltages at the anode and the cathode, and
- settling the voltage difference to the optimum available for the said battery.

Finally, the present invention provides a method for maximizing the life of a battery, comprising the following steps:

- providing an electrochemical cell based on lithium technology according to the present invention,
- measuring the voltage between

    (i) the anode and the reference electrode ($\Delta V_{anode}$) and/or
    (ii) the cathode and the reference electrode ($\Delta V_{cathode}$),

- determining the individual voltages at the anode and the cathode, and
- assessing whether the said voltages are too high and/or too low, and
- if required, correcting the voltage applied to the cathode and/or the anode to acceptable values.

The present invention includes batteries and accumulators of any type and for any use,e.g. batteries for consumer electronics (MP3 players, mobile phones), batteries for the automotive sector (e.g., batteries for electric and hybrid vehicles), large batteries for storing energy from renewable sources (e.g., solar and wind energy), and the like.
The following examples illustrate various embodiments of the electrochemical cell of the present invention as well as of measurement methods using same.

**Example 1: Preparation of electrodes**

Positive electrode: A positive electrode containing the cathode material lithium cobalt oxide ($LiCoO_2$) was

prepared by a casting process. The casting slurry consisted of a homogeneous mixture in acetone of $LiCoO_2$, graphite, carbon black, and PVDF as binder (Kynar LBG2) in the ratio 90%, 2.5%, 2.5%, and 5%, respectively. The slurry casting was done with a doctor-blade onto a plastic foil resting on a flat glass substrate. Following the evaporation of solvent the specific capacity of the cathode was determined to be 3.15 $mAh/cm^2$ and a thickness of 208 $\mu m$. The electrode material laminated onto an aluminum current collector with a thickness of 120 $\mu m$.

Negative electrode: A negative electrode containing the anode material graphite was prepared by a casting process. The casting slurry consisted of a homogeneous mixture in acetone of graphite, carbon black, and PVDF as binder (Kynar LBG2) in the ratio 85%, 5%, 10%, respectively. The slurry casting was done with a doctor-blade onto a plastic foil resting on a flat glass substrate. Following the evaporation of solvent the specific capacity of the anode was determined to be 3.47 $mAh/cm^2$ and a thickness of 135 $\mu m$. The electrode material laminated onto a copper current collector with a thickness of 120 $\mu m$.

Reference electrode: A reference electrode containing the reference electrode material lithium-titanate-oxide ($Li_4Ti_5O_{12}$) was prepared by a casting process. The casting slurry consisted of a homogeneous mixture in acetone of $Li_4Ti_5O_{12}$, carbon black, graphite, and PVDF as binder (Kynar LBG2) in the ratio 82%, 4%, 2% and 12%, respectively. The slurry casting was done with a doctor-blade onto a plastic foil resting on a flat glass substrate. Following the evaporation of solvent the specific capacity of the anode was determined to be 2.51 $mAh/cm^2$ and a thickness of 175 $\mu m$. The electrode material was laminated onto a copper current collector with a thickness of 120 $\mu m$.

## Example 2: Characterization of electrode materials

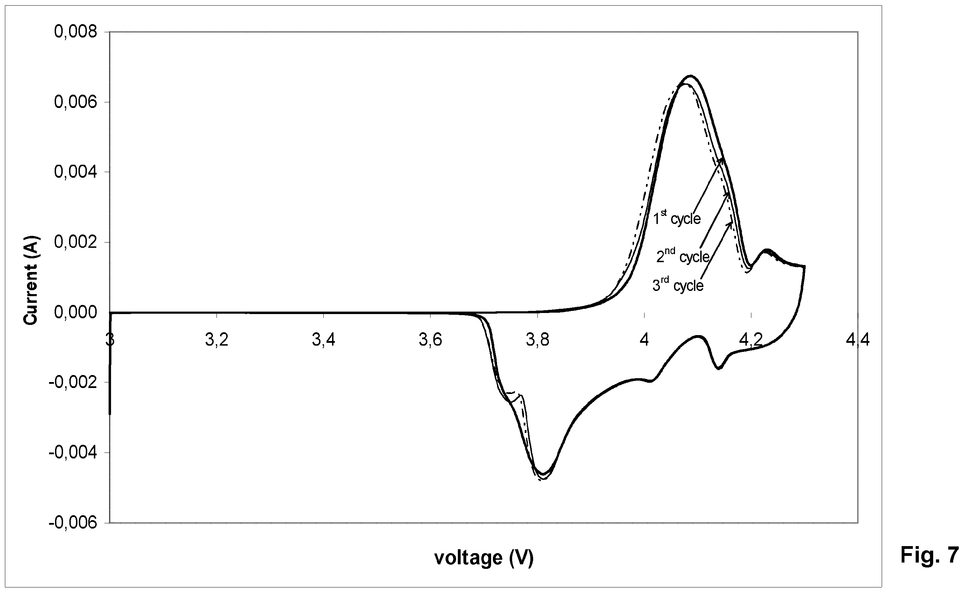

Linear sweep voltammetry (LSV) or cyclic voltammetry (CV) was performed on the three types of electrodes prepared according to Example 1. All experiments were carried out in electrochemical cells where lithium metal foil acted as a reference and counter electrode. The electrolyte used was a battery grade mixture of 1:1 ethylene carbonate (EC) and dimethylcarbonate (DEC) containing 1M $LiPF_6$. The electrode area of the working electrodes (i.e., cut out circles of electrode foils in **Example 1**) was 1.3 $cm^2$. All experiments were carried out under an argon atmosphere. Slow scan rates were used in order to better resolve voltammetric peaks. In particular, 10 $\mu V/s$ was used for both graphite and $Li_4Ti_5O_{12}$ and 100 $\mu V/s$ for $LiCoO_2$ to obtain the voltammograms of the electrodes **(Figs. 7-9)**.

With $LiCoO_2$ 3 cycles were carried out in order verify the evolution of the voltammetric peaks with multiple scans **(Fig. 7)**. In the case of $LiCoO_2$, there is a noticeable difference between the first and the second scans: the anodic peak shifts to a slightly negative voltage and a lower peak current whereas the cathodic current is marked by a resolution of a new peak (i.e., between 3.8 V and 3.7 V) on the second scan. The difference between the second and third scans is small, indicating that the formation of the active surface of $LiCoO_2$ is essentially complete by the third scan. This type of evolution of the CVs scans is in full agreement with literature (**Ref:** Dana A. Totir, Boris D. Cahan and Daniel A. Scherson, Electrochimica Acta 45, 161-166 (1999)) and attests to the with high quality $LiCoO_2$.electrodes.

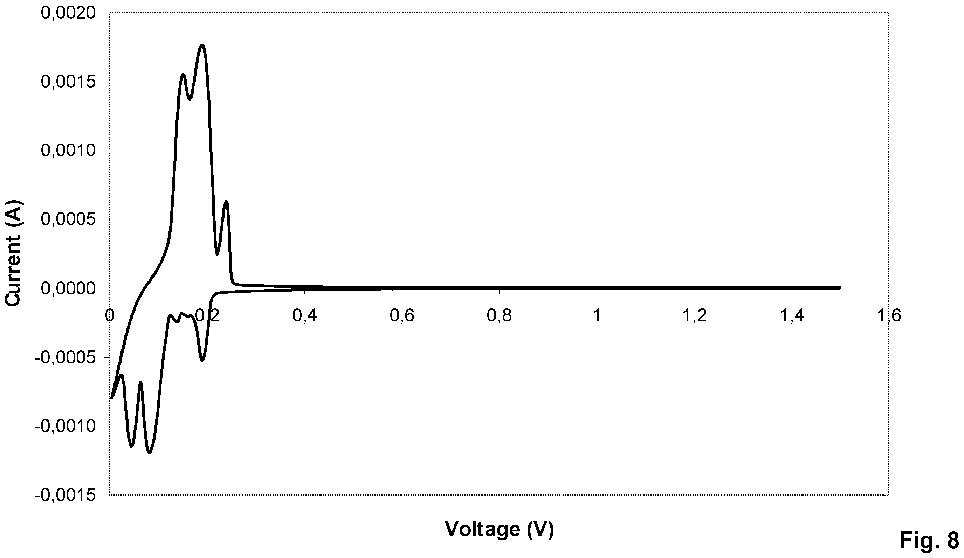

In the case of graphite, the peak evolution is much more drastic due to the formation of the classic solid-electrolyte-interface (SEI) described in literature (Ref: H. Wang and M. Yoshio, Journal of Power Sources 93, 123-129 (2001)). The uniformity of scans following the second scan indicates the SEI formation is complete. The **Fig. 8** shows the CV upon the third cycle. Here, too, the CV is in agreement with literature.

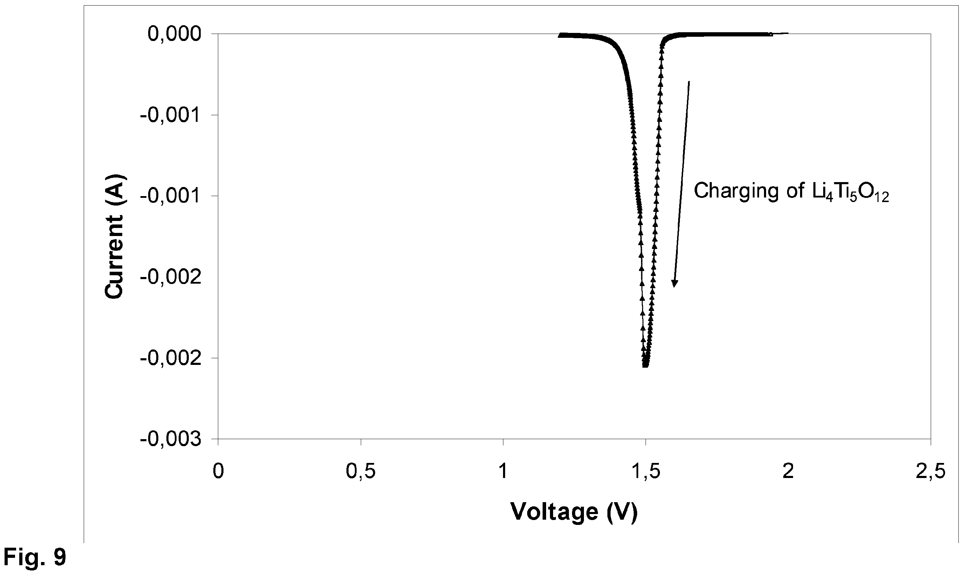

The LSV of $Li_4Ti_5O_{12}$ shows a sharp peak with a steep $\Delta A/\Delta V$ gradient **(Fig. 9)**. At the scan rate of 10 $\mu V/s$ of the sweep used in this experiment, the $\Delta A/\Delta V$ is ca 20 mV/mA. This very small gradient (which will be even smaller at lower sweep rates (A. J. Bard, L. R. Faulkner, "Electrochemical Methods: Fundamentals and Applications," 2nd ed., John Wiley & Sons, New York, 2000) and the absence of multiple and broad peaks as seen with $LiCoO_2$ and graphite supports the function of a classic non-polarizable electrode property (i.e., very little shift in voltage with increasing current) of a reference electrode, the method of use of $Li_4Ti_5O_{12}$ in this invention.

In summary, all three electrode materials (anode, cathode, and the reference electrode) produced in **Example 1** show the type of electrochemical performance expected of high quality electrodes and prove their suitability for the construction of full lithium polymer cells as described in the following **Examples 3-5**

## Example 3: Full cell design 1 and the construction thereof

Full cells were constructed using the electrode material prepared as described in Example 1 and a separator containing $Li_{1.3}Al_{0.3}Ti_{1.7}(PO_4)_3$ and PVDF in the ratio of 75% and 25%, respectively. The thickness of the separator was 55 $\mu m$. **Fig. 10** illustrates the cell construction scheme for one embodiment of the invention.

The cathode material was laminated onto aluminum current collector of 120 $\mu m$ thickness. The anode was laminated onto copper current collector of 120 $\mu m$ thickness. Both the cathode and the anode had outer dimensions of 58 x 33 mm with an indent of 8 x 5 mm cut into the electrodes from the center of one side. The separator was slightly oversized compared to the anode and cathode. The reference electrode material was laminated on to a copper current collector of 120 $\mu m$ thickness. The reference electrodes for the cell were obtained by cutting strips where the cut over the active electrode material ($Li_4Ti_5O_{12}$) was slightly undersized compared to the indent of the anode and cathode. A reference electrode strip was inserted between the two separators in a way that the reference electrode was directly aligned in the indent of the anode and cathode. The full system was laminated under heat and pressure. The resistance measurements showed that there was no electrical short-cut between the reference electrode and the other two electrodes. All laminated parts, including the reference electrode, were held together strongly as verified by the robustness of the components towards gentle pulling. The cell was housed in a heat-seal foil pouch, the standard electrolyte mixture of 1:1 ethylene carbonate (EC) and dimethylcarbonate (DEC) containing 1M $LiPF_6$ was filled, and the complete system sealed in a glove box under argon.

**Example 4: Full cell design 2 and the construction thereof**

Another embodiment of the invention is illustrated in **Fig. 11.** The electrode material used were the same described in Example 1. The design differs from that described in Example 2 in the following: i. The reference electrode is aligned along one of the long edges of the full cell, ii. the anode and cathode areas are 58 x 33 mm each and contain no indent. The full system was laminated under heat and pressure. The resistance measurements showed that there was no electrical short-cut between the reference electrode and the other two electrodes. All laminated parts, including the reference electrode, were held together strongly as verified by the robustness of the components towards gentle pulling. The cell was housed in a heat-seal foil pouch, the standard electrolyte mixture of 1:1 ethylene carbonate (EC) and dimethylcarbonate (DEC) containing 1M $LiPF_6$was filled, and the complete system sealed in a glove box under argon.

**Example 5: Other full cell designs**

Two other embodiments differing from those in Example 2 and 3 in that only one separator is used. Direct electrical contact between the reference electrode and the anode as well as the cathode are avoided by having an electrical insulation coating on the anode/cathode **(Fig. 12)** or on the reference electrode **(Fig. 13).** Alternatively, the electrical insulation coating could be made on both the reference electrode and anode/cathode for even better protection.

**Example 6: Establishing that the physical presence of a reference electrode does not perturb the normal charge-discharge behavior of a cell**

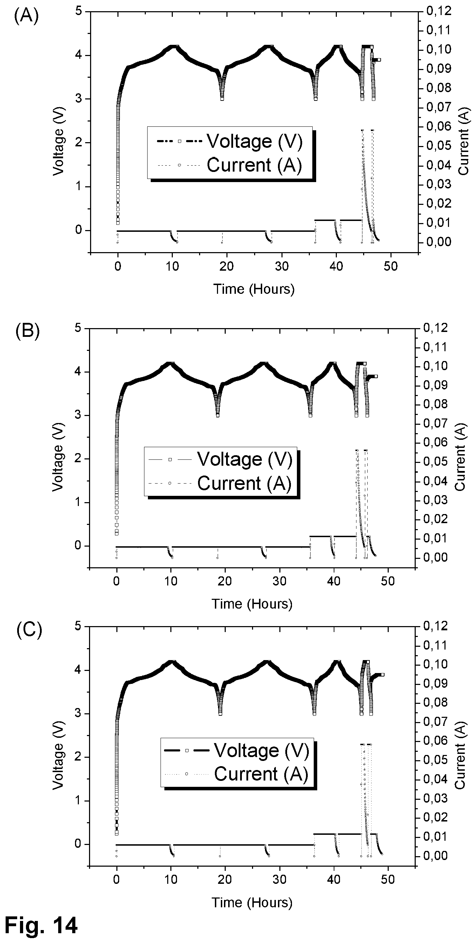

Two full-cells of the type described in Examples 3 and 4 were tested in the standard 2-electrode charge-discharge mode (i.e., without any use of the reference). A control experiment was conducted with a full cell without a reference electrode but otherwise identical in geometry and composition to the full-cell described in Example 4. The experiment would reveal whether the physical presence of the reference electrode would impact the performance of a battery. **Fig. 14** shows representative results from freshly prepared full-cells under the common constant current-constant voltage protocol (CC-CV) with a) two full cycles at 0.1C CC-phase, b) 1 full cycle with 0.2 C CC-phase, c) 1 full cycle with 1C CC-phase. The final resting potential was set to 3.8 V under 0.2 C. The voltage window was between 3.0 and 4.2 V. A TOSCAT 5200 battery cycler (Toyo Systems Co, Ltd, Japan). (CC means constant current; CV means constant voltage).

It is apparent from Fig. 14 that with respect to both the voltage vs. time plot and the current vs. time plot the profiles of the two full cells with reference electrodes (Fig. 14b and c) show similar behavior to the standard full cell (Fig. 14a). Therefore, it can be concluded that the physical presences of the reference electrode of the invention does not impact the normal charge-discharge behavior of a full cell.

**Example 7: Simultaneous measurement of voltage between a) anode-cathode,**

**b) cathode-reference, and c) anode-reference upon continuous charge-discharge cycles**

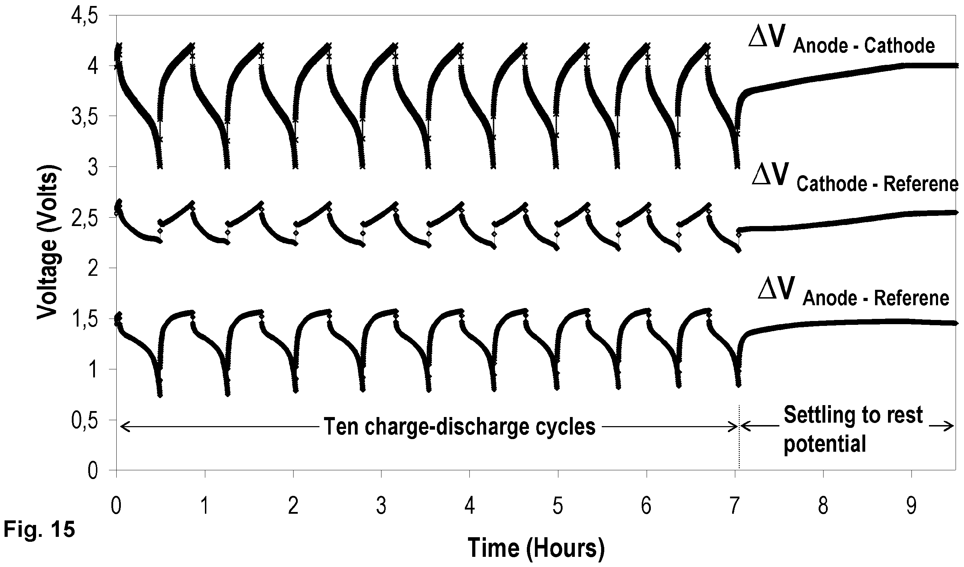

A three-electrode cell with a reference electrode as described in the invention was cycled 10 times under constant charge and discharge at 1C between 3.0V and 4.2V followed by settling rest potential of 4.0 V. In addition to the normal measurement of the voltage between the cathode and the anode ($\Delta V_{C-A}$), the same values were measured simultaneously between the anode and the reference electrode ($\Delta V_{A-Ref}$) and the cathode and the reference electrode ($\Delta V_{C-Ref}$). A TOSCAT 5200 battery cycler was used for the cycling while a voltmeter was used to measure the voltages between the reference electrode and the anode and cathode. The full set of voltage measurements are shown in **Fig. 15.** All voltage curves show identical periodicity with $\Delta V_{C-A} = \Delta V_{C-Ref} + \Delta V_{A-REF}$. This confirm that it is possible to measure $\Delta V_{A-Ref}$ and $\Delta V_{C-Ref}$ simultaneously. Here the anode and cathode voltages are given with respect to the lithium titanate (LTO) reference electrode. Based on the LTO electrochemical potential versus lithium, it is possible to calculate the voltage windows for the anode and cathode with respect to $Li/Li^+$ or any other reference voltage if necessary.

**Example 8: Measurement of the impedance of the anode and cathode loop in a 3-electrode battery using the reference electrode**

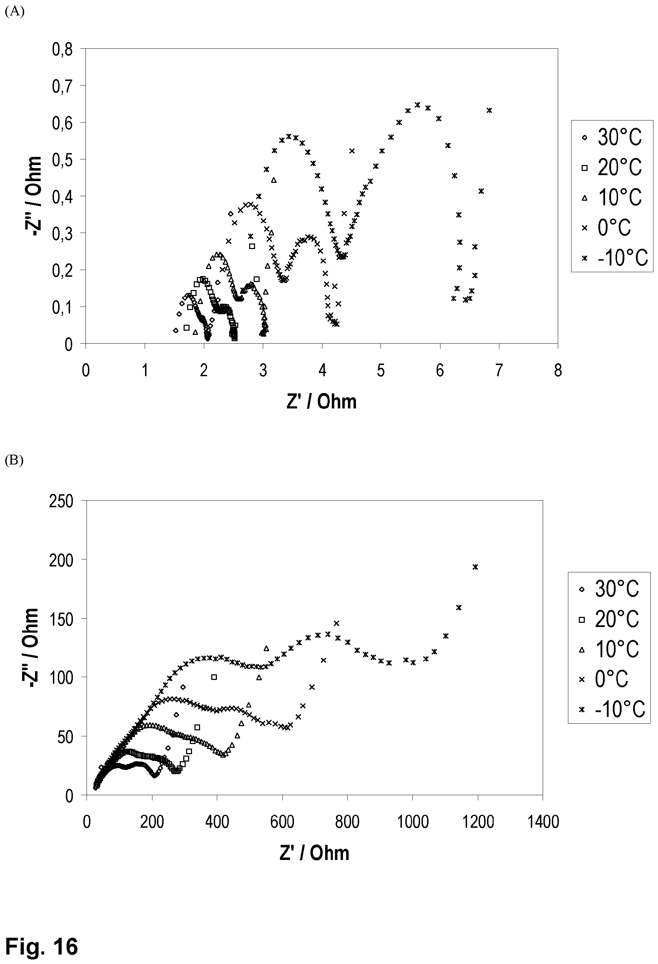

Impedance measurements were made using a Zahner IM6 (Zahner-elektrik GmbH, Kronach, Germany). In order to verify the behavior and relationship between the impedance loops across the anode and cathode ($Z_{C-A}$), the anode and reference ($Z_{A-Ref}$), and the cathode and reference ($Z_{C-Ref}$), the temperature was varied between -10°C and 30°C while the voltage was held constant at 4.0V. The impedance is known to be directly related to the temperature, thus providing a very convenient method to probe the impedance. **Fig. 16** shows the impedance measurements across $Z_{C-A}$ and $Z_{A-Ref}$ loops in the form of Nyquist plots. The impedance shows a clear increase with decreasing temperature as evident in the increasing width of the semicircles. In terms of absolute values, the $Z_{C-A} < Z_{A-Ref}$ due to the much larger surface area of the anode and cathode compared to the reference electrode, but qualitatively the impedance behavior remains very similar. **Fig. 17** shows the Arhenius plot of $Z_{C-A}$, $Z_{A-Ref}$, $Z_{C-Ref}$ versus 1/temperature for the impedance measured at 100 mHz. Here, the data suggest that

$Z_{A-Ref}$ and $Z_{C-Ref}$ are nearly equal over the temperature range. This is to be expected considering that the decreasing temperatures are most likely to affect the impedance over the separator because of the well-known decrease in conductivity of the electrolyte within the separator with decreasing temperature. This experiment, therefore, illustrates the feasibility of measuring and following $Z_{C-A}$, $Z_{A-Ref}$, $Z_{C-Re}$ and thus enabling the useful diagnostics of battery performance described in 1.4.

**Example 9: Simultaneous measurement of voltage between a) anode-cathode, b) cathode-reference, and c) anode-reference in 3-electrode cell upon continuous charge-discharge cycles at varying rates**

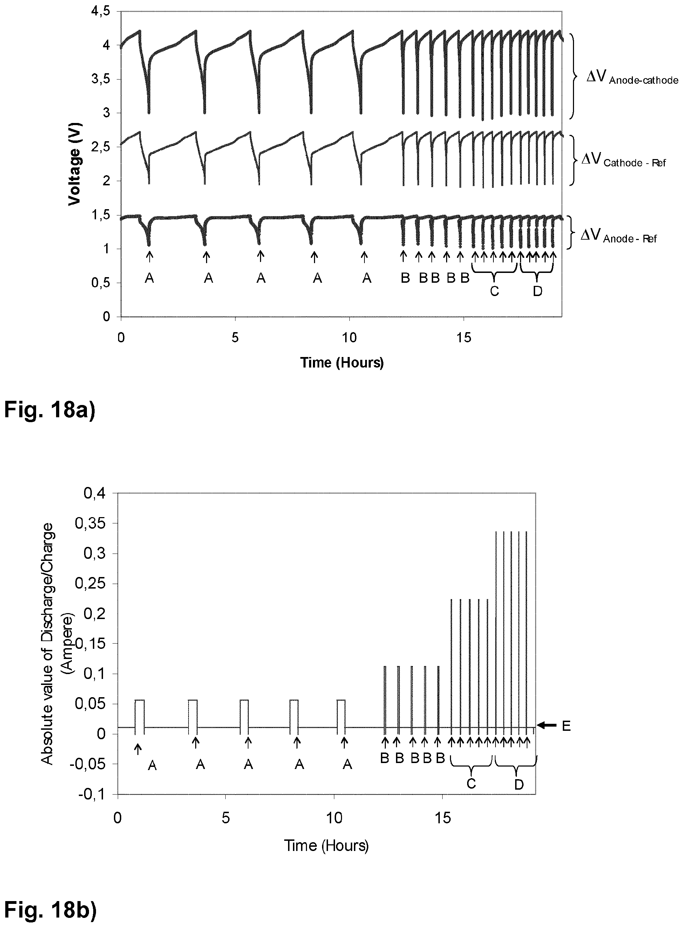

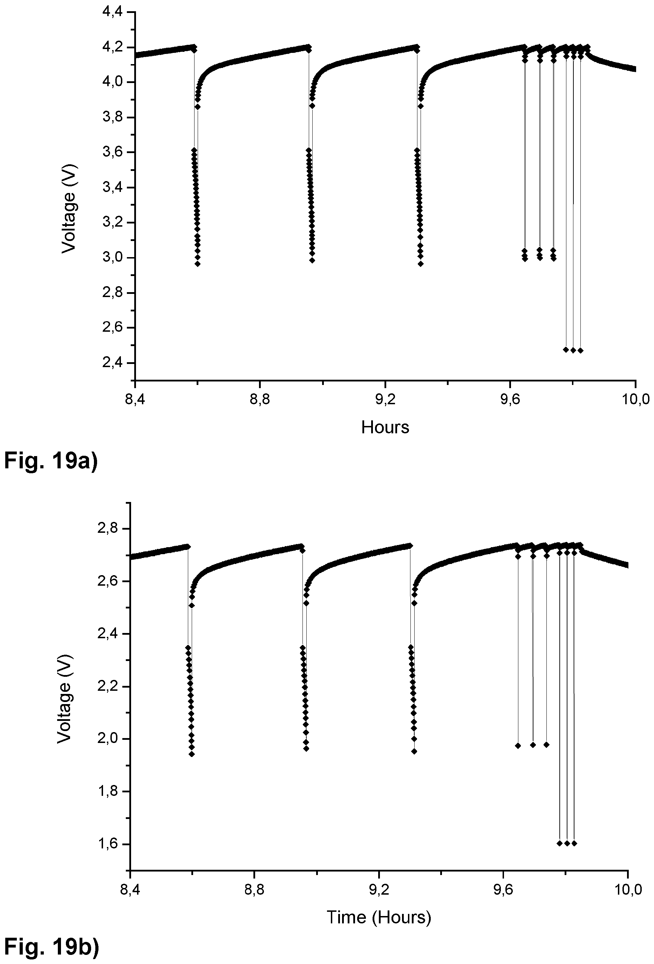

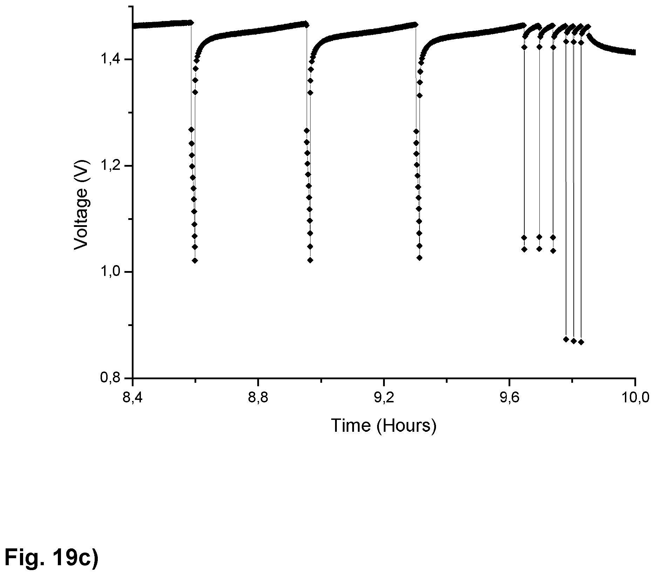

A battery with a reference electrode was cycled under similar conditions as described in Example 7 except the charge-discharge profile followed the charging at a constant 0.2C and the discharging at 1C, 2C, 4C, and 6C. Four discharges were made at each discharge rate and the full cell voltage window was set to 3.0 - 4.2V. **Fig. 18a shows** the simultaneous measurements of the voltage between a) anode-cathode, b) cathode-reference, and c) anode-reference. **Fig. 18b** shows the current versus time plot corresponding to the voltage above voltage curve. In this particular case, the results illustrate the important role of a reference electrode in determining the contributions of the anode and cathode to the overall cell voltage. For example, during charging the anode reaches its voltage plateau rapidly whereas the cathode rises slowly along with the rising voltage of the full cell. In a separate experiment, the discharge rate was increased drastically to determine the onset of a voltage breach due to the high power applications as described in 1.3.2. **Fig. 19** shows the voltage profiles for 0.2C charge and 8C, 16C, and 32 C discharge rates with three charge-discharge cycles at different C rates. The general behavior seen in Fig. 18 is continued up to 16C. However, a significant overshoot of voltage takes place at 32C. In this case, the discharge is so rapid that by the time the first data point for the discharge is obtained, the voltage had exceeded the 3.0V discharge limit. This also causes the voltage of the anode and cathode to exceed (compared to lower C rates) the limits by approximately 300 mV on the cathode side and 150 mV on the anode side.

**Example 10: Simultaneous measurement of voltage between a) anode-cathode, b) cathode-reference, and c) anode-reference using a lithium iron phosphate (LFP) reference electrode.**

A further example of the simultaneous measurement of the above three voltages (between cathode and anode ($\Delta V_{C-A}$), cathode and reference ($\Delta V_{C-R}$) and reference and anode ($\Delta V_{R-A}$)) is presented for the use of lithium iron phosphate ($LiFePO_4$ or LFP) as the reference electrode. The preparation of the cell was made as in the above case of Example 7 with the main difference being the reference electrode (LFP here). The LFP reference electrode material was prepared similar to the LTO electrode in Example 1 with the capacity of LFP being 0.7 mAh/cm$^2$.

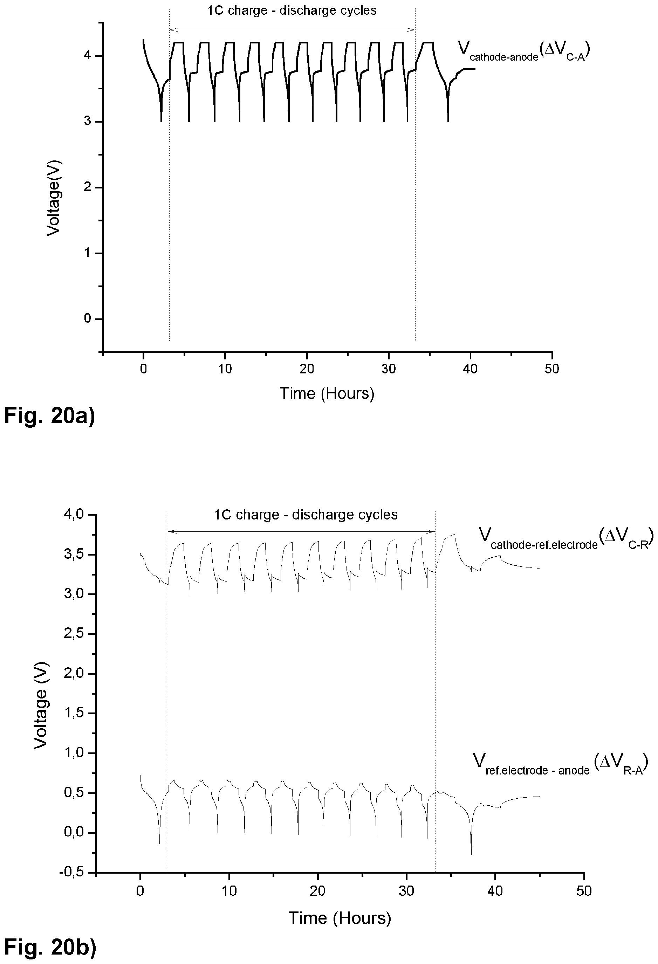

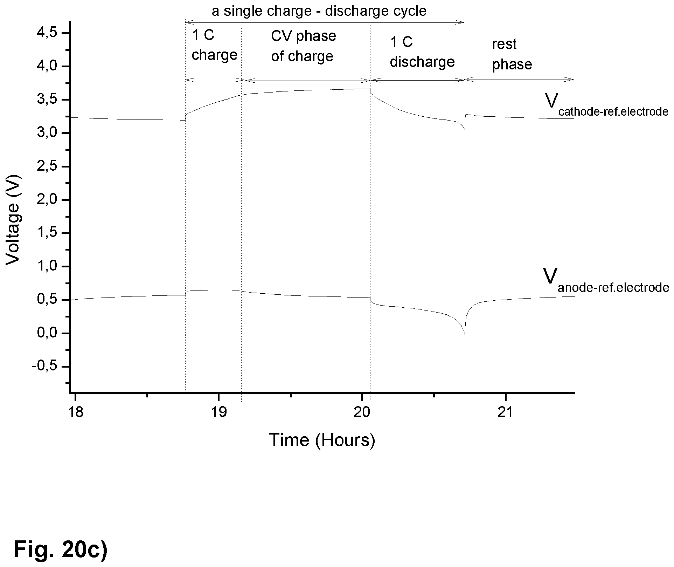

The cell was tested with a charge-discharge cycle profile consisting of a constant-current (CC) and constant voltage (CV) charging and CC discharge. The exact sequence was as follows: (1) Discharge to 3.0 V at 0.5 C, (2) 10 cycles with each cycle having i) charge to 4.2 V at 1 C followed by a CV phase (cut-off set to current matching current of 1/10 C) ii) 1 C discharge to 3.0 V and iii) rest at open-circuit potential for 1 hour, (3) 1 cycle with i) charge to 4.2 V at 0.5 C followed by a CV phase (cut-off set to a current corresponding to 1/10 C) ii) 0.5 C discharge to 3.0 V and iii) rest at open-circuit potential for 1 hour, and (4) bring to rest at 3.7 V. **Fig. 20** shows the voltage profile between the anode and the cathode (Fig. 20a) and the voltages measured simultaneously between the anode and cathode versus the reference electrode (Fig. 20b). The characteristics of a single charge-discharge cycle are seeing more clearly in the zoomed view (Fig. 20c).

All voltage curves show identical periodicity with $\Delta V_{C-A} = \Delta V_{C-R} + \Delta V_{R-A}$, which confirms the possibility to measure all three voltages simultaneously using a reference electrode consisting of LFP. In this example, the voltage profiles at the anode and cathode distinguish the different characteristics (i.e., significantly greater voltage shifts at the cathode compared to the anode during charging, a greater voltage swing at the anode compared to the cathode during open circuit resting). Such information cannot be obtained with the state-of-the-art two electrode cells and is made possible here only with the aid of the reference electrode which contains LFP in this example.

**Example 11: Simultaneous measurement of voltage between a) anode-cathode, b) cathode-reference, and c) anode-reference during pulse discharge**

In the above examples of full cell tests, the charge and discharge profiles were all continuous in character (i.e., constant charging and discharging currents). Here the testing is extended to rapid discharge pulse profiles representative of typical high power characterization methods of batteries. In particular, the test is designed to ascertain the suitability of the invention to monitor the rapid voltage pulses at the anode and cathode, with the aforementioned advantages such capability offers. A cell similar to that used in Example 7 was used where the reference electrode was an LTO reference electrode.

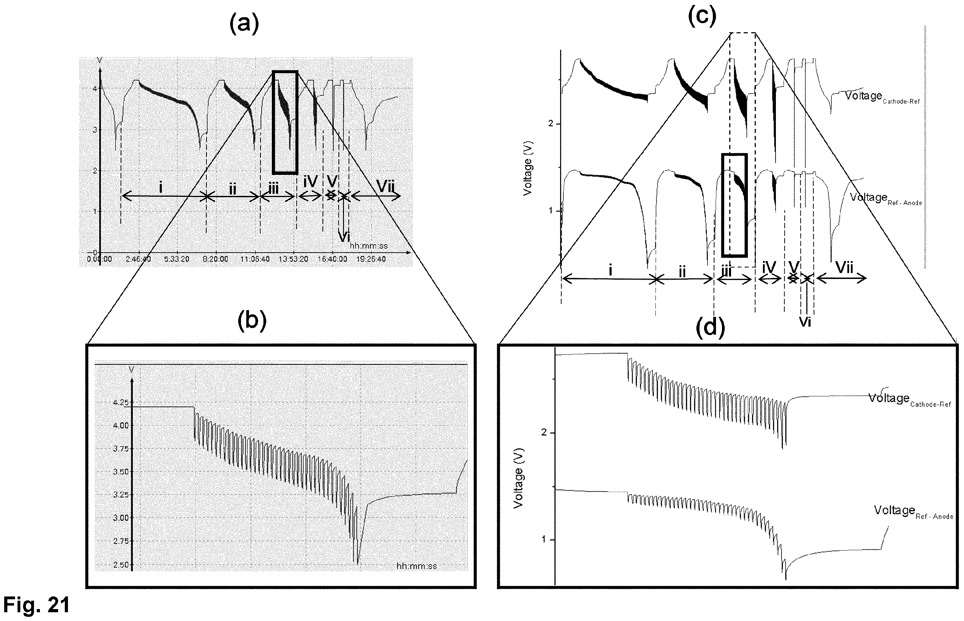

**Fig. 21** shows a series of charge-discharge cycles between 3.0 V and 4.2 V. Fig. 21(a) and (b) show the voltage between the anode and cathode ($\Delta V_{C-A}$) and Fig. 21 (c) and (d) show the voltages at the anode ($\Delta V_{R-A}$) and cathode ($\Delta V_{C-R}$) as measured against the reference electrode. All charging events were performed at 0.2 C CC-CV. The discharges were done over the range of 1- 30 C as shown in Fig. 21 where i) is 1 C, ii) 2C, iii) 5C, iV) 10C, v) 20C and vi) 30C. Here, each pulse was 18 seconds long and was followed by a 60 second open-circuit rest period before the next pulse. A 30 minute rest at open-circuit potential was allowed between discharging and charging. The results illustrate that, as expected, the time taken to complete a discharge process is inversely related to the C-rate. More importantly, here too all voltage curves show identical periodicity with $\Delta V_{C-A} = \Delta V_{C-R} + \Delta V_{R-A}$, which confirms the possibility to measure $\Delta V_{R-A}$ and $\Delta V_{C-R}$ simultaneously using a reference electrode under pulse discharge conditions. Furthermore, the dynamic voltage profiles observed throughout the pulse discharges enables the tracking of the voltages at the anode and cathode in fine and exact detail even during a single 18 second pulse.

**Example 12: Simultaneous measurement of voltage between a) anode-cathode, b) cathode-reference, and c) anode-reference during pulse charge**

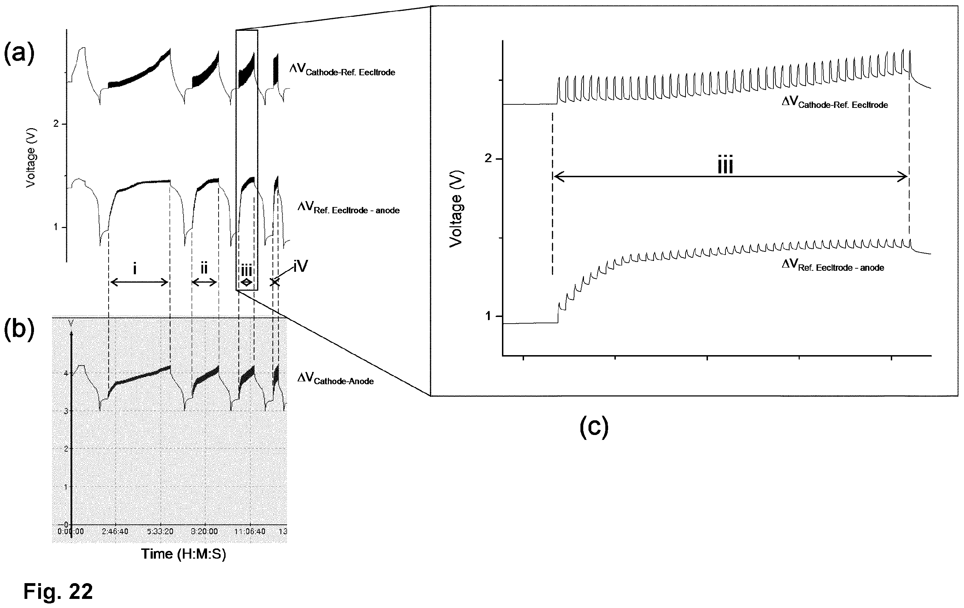

Here the same system as used in Example 11 was used to determine the anode and cathode behavior during pulse charge. As shown in **Fig. 22,** pulse charging was done at i) 1C, ii) 2C, iii) 3C, and iV) 5C with each pulse being 18 seconds long followed by a 60 second open-circuit rest period before the next pulse. The discharging was always done at 1C in constant current (CC) and a 30 minute rest at open-circuit potential was allowed before charging again. Here, too, the results illustrate that the time taken to complete a charge process is inversely related to the C-rate. More importantly, all voltage curves show identical periodicity with $\Delta V_{C-A} = \Delta V_{C-R} + \Delta V_{R-A}$, which confirms the possibility to measure $\Delta V_{R-A}$ and $\Delta V_{C-R}$ simultaneously using a reference electrode under pulse charge conditions. The voltage profiles remains dynamic throughout the pulse charges thus enabling the tracking of the voltages at the anode and cathode in exact detail even during a single pulse.

**Claims**

1.  Electrochemical cell based on lithium technology, comprising the following components

    - a positive electrode containing a cathode material,
    - a separator made of an electrically insulating material,
    - a negative electrode containing an anode material,
    the electrodes and the separator having sheet form,
    - a liquid and/or solid ion conductor material for transportation of lithium ions between the positive and the negative electrode,

    the said components being sealed within a casing, wherein the positive electrode and the negative electrode each comprise an electrically conducting structure extending through a wall of the casing for further electrical connection, **characterized in that** it further comprises:

    - a reference electrode within the said casing which is electrically insulated from the positive and the negative electrodes and has a distance of at least 1.5 mm to the adjacent electrode, the reference electrode comprising an electrically conducting metallic foil or sheet extending through a wall of the casing for further electrical connection and being covered with reference electrode material having layer form such that it is in electrical contact with the electrically conducting metallic foil or sheet and comprising at least one non-metallic lithium compound within the said casing.

2. Electrochemical cell based on lithium technology according to claim 1, wherein the distance between the boundaries of the reference electrode and those of the adjacent electrode is at least 1.6 mm, preferably at least 2.1 mm and more preferably at least 2.8 mm.

3. Electrochemical cell based on lithium technology according to any of the preceding claims, wherein the reference electrode is electrically insulated from the negative electrode and from the positive electrode via the separator material and/or via an electrically insulating coating provided on the reference electrode and/or on one or both of the electrodes.

4. Electrochemical cell based on lithium technology according to any of the preceding claims, wherein the electrodes and the separator are arranged one atop the other in z-direction, and each covering an area in an x-y direction and if the battery is seen from above (in z-direction), the reference electrode is placed outside the area which is covered by the positive electrode and/or of the negative electrode.

5. Electrochemical cell based on lithium technology according to any of the preceding claims, wherein the electrodes and the separator are arranged one atop the other in z-direction, and each covering an area in an x-y direction, wherein the length or the width of the separator layer is larger than that of the electrode layers and the layers are placed one on top the other such that the separator layer projects from the electrode layers on one side of the battery, **characterized in that** the reference electrode is attached to the separator layer along its projecting length.

6. Electrochemical cell based on lithium technology according to any of the preceding claims, wherein the electrodes and the separator are arranged one atop the other in z-direction, and each covering an area in an x-y direction, **characterized in that** at least one of the electrodes has a recess or notch cut out of the layer, and the reference electrode, seen in z-direction, is placed in the area of the said notch or recess of one of the electrodes.

7. Electrochemical cell based on lithium technology according to claim 6, wherein the reference electrode is placed on one of the cathode current collector and the anode current collector, separated therefrom by an insulating material, such that it is situated within the recess or notch of the adjacent electrode.

8. Electrochemical cell based on lithium technology according to any of the preceding claims, wherein the non-metallic lithium compound is selected such that the electrode has a flat voltage versus lithium-ion concentration profile, and preferably under the group consisting of $Li_4Ti_5O_{12}$, $LiFePO_4$, $Li(Ni_{0.5}Mn_{1.5})O_4$, $LiMn_2O_4$, and $LiCo_{1/3}Ni_{1/3}Mn_{1/3}O_2$ (NMC).

9. Electrochemical cell based on lithium technology according to any of the preceding claims, wherein the reference electrode collector is covered with reference electrode material on both sides.

10. Electrochemical cell based on lithium technology according to any of the preceding claims, **characterized in that** it contains two or more reference electrodes.

11. Method for the production of an electrochemical cell based on lithium technology as claimed in any of the preceding claims, comprising the following steps:

- providing a positive electrode connected to an electrically conducting structure,
- providing a negative electrode connected to an electrically conducting structure,
- providing a reference electrode, the reference electrode comprising an electrically conducting metallic foil or sheet being covered with reference electrode material having layer form such that it is in electrical contact with the electrically conducting metallic foil or sheet and comprising at least one non-metallic lithium compound within the said casing,

- providing a separator made of an electrically insulating material,
- arranging the electrodes and the separator under formation of an electrochemical cell, wherein the reference electrode has a distance of at least 1.5 mm to the adjacent electrode and is electrically insulated from the positive and the negative electrodes, and
- tightly encapsulating the components of the electrochemical cell within a casing such that an electrically conducting structure of each of the electrodes and the electrically conducting metal foil or sheet of the reference electrode extends through a wall of the casing for further electrical connection.

12. A method for measuring the voltage of a cathode and/or of an anode of an electrochemical cell based on lithium technology, wherein the cell includes the following components:

- a positive electrode containing a cathode material,
- a separator made of an electrically insulating material,
- a negative electrode containing an anode material,
the electrodes and the separator having layer or sheet form,
- a liquid and/or solid ion conductor material for transportation of lithium ions between the positive and the negative electrode,
- a reference electrode which is electrically insulated from the positive and the negative electrodes and has a distance of at least 1.5 mm to the adjacent electrode, comprising an electrically conducting metallic foil or sheet being covered with reference electrode material having layer form such that it is in electrical contact with the electrically conducting metallic foil or sheet and comprising at least one non-metallic lithium compound within the said casing,

the said components being sealed within a casing, wherein the positive electrode and the negative electrode each comprise an electrically conducting structure which, as well as the electrically conducting metal foil or sheet of the reference electrode, extend through a wall of the casing for further electrical connection,
the method including the following steps:

(a) charging and/or discharging the cell once or more times,
(b) measuring the voltage between the cathode and the reference electrode and/or between the anode and the reference electrode once or more times, and subsequently
(c) settling the rest potential to a value selected from the range between the charge and discharge value.

13. Method according to claim 12, wherein the anode and/or cathode voltage is measured by measuring the voltage between the cathode and the reference electrode or the voltage between the anode and the reference electrode, and a state-of-charge (SOC) of the cell is derived therefrom, using a pre-determined calibration curve relating the SOC of the cell to the anode or cathode voltage.

14. A method for measuring impedance of a cathode and of an anode of an electrochemical cell based on lithium technology independently, **characterized in that** the cell includes the following components:

- a positive electrode containing a cathode material,
- a separator made of an electrically insulating material,
- a negative electrode containing an anode material,
the electrodes and the separator having layer or sheet form,
- a liquid and/or solid ion conductor material for transportation of lithium ions between the positive and the negative electrode,
- a reference electrode which is electrically insulated from the positive and the negative electrodes and has a distance of at least 1.5 mm to the adjacent electrode, comprising an electrically conducting metallic foil or sheet being covered with reference electrode material having layer form such that it is in electrical contact with the electrically conducting metallic foil or sheet and comprising at least one non-metallic lithium compound within the said casing,

the said components being sealed within a casing, wherein the positive electrode and the negative electrode each comprise an electrically conducting structure which, as well as the electrically conducting metallic foil or sheet of the reference electrode, extend through a wall of the casing for further electrical connection,
the method including the following steps:

(a) applying a constant voltage between the cathode and the anode
(b) measuring the impedance across at least one of the $Z_{C-Ref}$ and $Z_{A-Ref}$ loops, wherein C is the cathode, A is the anode, and Ref is the reference electrode.

15. A method for an assessment of aging of at least one of the electrodes of an electrochemical cell, comprising carrying out the method of claim 14 and including the additional steps:

(c) assessing whether the said impedances are within an acceptable range

- if no, terminating the cell;
- if yes, re-measuring the impedance and repeating the loop, and either

(d) logging the impedance rise of the anode and cathode to estimate the aging of each and thereby estimate the life-time of the cell, and/or
(e) estimating the power capability losses at the anode and/or cathode by associated impedances.

16. A method for driving an electrochemical cell based on lithium technology, comprising the following steps:

- providing an electrochemical cell based on lithium technology according to any of claims 1 to 10,
- measuring the voltage between

(i) the anode and the reference electrode ($\Delta V_{anode}$) and/or
(ii) the cathode and the reference electrode ($\Delta V_{cathode}$),

- checking whether the said voltages are within an acceptable range, and
- either, if yes, measuring the said voltages again, if required,
- or, if no, checking whether the magnitude of voltage breach is beyond a critical point, and

- if yes, terminating the operation of the cell, or
- if no, varying the charging rate and/or discharging rate and subsequently measuring the said voltages again, if required.

17. A method for maximizing the life of a battery, comprising the following steps:

- providing an electrochemical cell based on lithium technology according to any of claims 1 to 10,
- measuring the voltage between

(i) the anode and the reference electrode ($\Delta V_{anode}$) and/or
(ii) the cathode and the reference electrode ($\Delta V_{cathode}$),

- determining the individual voltages at the anode and the cathode, and
- assessing whether the said voltages are too high and/or too low, and
- if required, correcting the voltage applied to the cathode and/or the anode to acceptable values.

**Patentansprüche**

1. Elektrochemische Zelle auf Basis der Lithiumtechnologie, welche die folgenden Komponenten beinhaltet:

- eine positive Elektrode, die ein Kathodenmaterial enthält,
- einen Separator aus einem elektrisch isolierenden Material,
- eine negative Elektrode, die ein Anodenmaterial enthält,
wobei die Elektroden und der Separator plattenförmig sind,
- ein flüssiges und/oder festes Ionenleitermaterial für den Transport von Lithiumionen zwischen der positiven und der negativen Elektrode,

wobei die Komponenten innerhalb eines Gehäuses abgedichtet sind, wobei die positive Elektrode und die negative Elektrode jeweils eine elektrisch leitende Struktur aufweisen, die sich durch eine Wand des Gehäuses zur weiteren elektrischen Verbindung erstreckt,
**dadurch gekennzeichnet, dass** sie ferner beinhaltet:

- eine Referenzelektrode innerhalb des Gehäuses, die von der positiven und der negativen Elektrode elektrisch isoliert ist und einen Abstand von mindestens 1,5 mm zu der benachbarten Elektrode aufweist, wobei die Referenzelektrode eine elektrisch leitende Metallfolie oder -platte beinhaltet, die sich durch eine Wand des Gehäuses zur weiteren elektrischen Verbindung erstreckt und mit eine Schichtform aufweisendem Referenzelektrodenmaterial derart bedeckt ist, dass es in elektrischem Kontakt mit der elektrisch leitenden Metallfolie oder -platte steht, und mindestens eine nichtmetallische Lithiumverbindung innerhalb des Gehäuses beinhaltet.

**2.** Elektrochemische Zelle auf Basis der Lithiumtechnologie nach Anspruch 1, wobei der Abstand zwischen den Grenzen der Referenzelektrode und denen der benachbarten Elektrode mindestens 1,6 mm, vorzugsweise mindestens 2,1 mm und noch bevorzugter mindestens 2,8 mm beträgt.

**3.** Elektrochemische Zelle auf der Basis der Lithiumtechnologie nach einem der vorstehenden Ansprüche, wobei die Referenzelektrode von der negativen Elektrode und von der positiven Elektrode über das Separatormaterial und/oder über eine elektrisch isolierende Beschichtung, die auf der Referenzelektrode und/oder auf einer oder beiden Elektroden vorgesehen ist, elektrisch isoliert ist.

**4.** Elektrochemische Zelle auf der Basis der Lithiumtechnologie nach einem der vorstehenden Ansprüche, wobei die Elektroden und der Separator in z-Richtung übereinander angeordnet sind und jeweils eine Fläche in x-y-Richtung abdecken, und wenn die Batterie von oben (in z-Richtung) gesehen wird, die Referenzelektrode außerhalb der Fläche angeordnet ist, die von der positiven Elektrode und/oder der negativen Elektrode abgedeckt wird.

**5.** Elektrochemische Zelle auf der Basis der Lithiumtechnologie nach einem der vorstehenden Ansprüche, wobei die Elektroden und der Separator in z-Richtung übereinander angeordnet sind und jeweils eine Fläche in x-y-Richtung abdecken, wobei die Länge oder die Breite der Separatorschicht größer ist als die der Elektrodenschichten und die Schichten so übereinander angeordnet sind, dass die Separatorschicht auf einer Seite der Batterie aus den Elektrodenschichten herausragt, **dadurch gekennzeichnet, dass** die Referenzelektrode entlang ihrer herausragenden Länge an der Separatorschicht befestigt ist.

**6.** Elektrochemische Zelle auf der Basis der Lithiumtechnologie nach einem der vorstehenden Ansprüche, bei der die Elektroden und der Separator in z-Richtung übereinander angeordnet sind und jeweils eine Fläche in x-y-Richtung abdecken, **dadurch gekennzeichnet, dass** mindestens eine der Elektroden eine Aussparung oder Kerbe aufweist, die in der Schicht ausgeschnitten ist, und die Referenzelektrode, in z-Richtung gesehen, in der Zone der besagten Kerbe oder Aussparung einer der Elektroden angeordnet ist.

**7.** Elektrochemische Zelle auf Basis der Lithiumtechnologie nach Anspruch 6, bei der die Referenzelektrode entweder auf dem Kathodenstromabnehmer oder dem Anodenstromabnehmer angeordnet ist und davon durch ein isolierendes Material getrennt ist, so dass sie sich innerhalb der Aussparung oder Kerbe der benachbarten Elektrode befindet.

**8.** Elektrochemische Zelle auf der Basis der Lithiumtechnologie nach einem der vorstehenden Ansprüche, wobei die nichtmetallische Lithium-Verbindung so ausgewählt ist, dass die Elektrode ein flaches Spannungs-/Lithium-Ionen-Konzentrationsprofil aufweist, und vorzugsweise unter der Gruppe bestehend aus $Li_4Ti_5O_{12}$, $LiFePO_4$, $Li(Ni_{0,5}Mn_{1,5})O_4$, $LiMn_2O_4$ und $LiCo_{1/3}Ni_{1/3}Mn_{1/3}O_2$ (NMC) ausgewählt ist.

**9.** Elektrochemische Zelle auf Basis der Lithiumtechnologie nach einem der vorstehenden Ansprüche, wobei der Referenzelektroden-Kollektor auf beiden Seiten mit Referenzelektrodenmaterial bedeckt ist.

**10.** Elektrochemische Zelle auf Basis der Lithiumtechnologie nach einem der vorstehenden Ansprüche, **dadurch gekennzeichnet, dass** sie zwei oder mehr Referenzelektroden enthält.

**11.** Verfahren zur Herstellung einer elektrochemischen Zelle auf Basis der Lithiumtechnologie, wie in einem der vorstehenden Ansprüche beansprucht, umfassend die folgenden Schritte:

- Bereitstellen einer positiven Elektrode, die mit einer elektrisch leitenden Struktur verbunden ist,
- Bereitstellen einer negativen Elektrode, die mit einer elektrisch leitenden Struktur verbunden ist,
- Bereitstellen einer Referenzelektrode, wobei die Referenzelektrode eine elektrisch leitende Metallfolie oder eine elektrisch leitende Metallplatte umfasst, die mit einem eine Schichtform aufweisenden Referenzelektrodenmaterial derart bedeckt ist, dass es in elektrischem Kontakt mit der elektrisch leitenden Metallfolie oder elektrisch leitenden Metallplatte steht, und mindestens eine nichtmetallische Lithiumverbindung innerhalb des Gehäuses beinhaltet,
- Bereitstellen eines Separators aus elektrisch isolierendem Material,

- Anordnen der Elektroden und des Separators unter Bildung einer elektrochemischen Zelle, wobei die Referenzelektrode einen Abstand von mindestens 1,5 mm zu der benachbarten Elektrode aufweist und von der positiven und der negativen Elektrode elektrisch isoliert ist, und

- dichtes Einkapseln der Komponenten der elektrochemischen Zelle innerhalb eines Gehäuses, so dass eine elektrisch leitende Struktur jeder der Elektroden und die elektrisch leitende Metallfolie oder die elektrisch leitende Metallplatte der Referenzelektrode sich durch eine Wand des Gehäuses zur weiteren elektrischen Verbindung erstreckt.

12. Verfahren zum Messen der Spannung einer Kathode und/oder einer Anode einer auf der Lithiumtechnologie basierenden elektrochemischen Zelle, wobei die Zelle die folgenden Komponenten beinhaltet:

- eine positive Elektrode, die ein Kathodenmaterial enthält,
- einen Separator aus einem elektrisch isolierenden Material,
- eine negative Elektrode, die ein Anodenmaterial enthält,

wobei die Elektroden und der Separator schicht- oder plattenförmig sind,

- ein flüssiges und/oder festes Ionenleitermaterial für den Transport von Lithiumionen zwischen der positiven und der negativen Elektrode,
- eine Referenzelektrode, die von der positiven und der negativen Elektrode elektrisch isoliert ist und einen Abstand von mindestens 1,5 mm zu der benachbarten Elektrode aufweist, beinhaltend eine elektrisch leitende Metallfolie oder -platte, die mit eine Schichtform aufweisenden Referenzelektrodenmaterial derart bedeckt ist, dass es in elektrischem Kontakt mit der elektrisch leitenden Metallfolie oder -platte steht, und mindestens eine nichtmetallische Lithiumverbindung innerhalb des Gehäuses beinhaltet,

wobei die Komponenten innerhalb eines Gehäuses abgedichtet sind, wobei die positive Elektrode und die negative Elektrode jeweils eine elektrisch leitende Struktur aufweisen, die sich ebenso wie die elektrisch leitende Metallfolie oder die elektrisch leitende Metallplatte der Referenzelektrode durch eine Wand des Gehäuses zur weiteren elektrischen Verbindung erstrecken,
wobei das Verfahren die folgenden Schritte umfasst:

(a) ein- oder mehrmaliges Laden und/oder Entladen der Zelle,
(b) ein- oder mehrmaliges Messen der Spannung zwischen der Kathode und der Referenzelektrode und/oder zwischen der Anode und der Referenzelektrode und anschließendes
(c) Einstellen des Ruhepotentials auf einen aus dem Bereich zwischen dem Lade- und Entladewert ausgewählten Wert.

13. Verfahren nach Anspruch 12, wobei die Anoden- und/oder Kathodenspannung durch Messen der Spannung zwischen der Kathode und der Referenzelektrode oder der Spannung zwischen der Anode und der Referenzelektrode gemessen wird und daraus ein Ladungszustand (SOC) der Zelle abgeleitet wird, wobei eine vorbestimmte Kalibrierkurve verwendet wird, die den SOC der Zelle mit der Anoden- oder Kathodenspannung in Beziehung setzt.

14. Verfahren zum unabhängigen Messen der Impedanz einer Kathode und einer Anode einer elektrochemischen Zelle auf der Basis der Lithiumtechnologie, **dadurch gekennzeichnet, dass** die Zelle die folgenden Komponenten beinhaltet:

- eine positive Elektrode, die ein Kathodenmaterial enthält,
- einen Separator aus einem elektrisch isolierenden Material,
- eine negative Elektrode, die ein Anodenmaterial enthält,
wobei die Elektroden und der Separator schicht- oder plattenförmig sind,
- ein flüssiges und/oder festes Ionenleitermaterial für den Transport von Lithiumionen zwischen der positiven und der negativen Elektrode,
- eine Referenzelektrode, die von der positiven und der negativen Elektrode elektrisch isoliert ist und einen Abstand von mindestens 1,5 mm zu der benachbarten Elektrode aufweist, beinhaltend eine elektrisch leitende Metallfolie oder -platte, die mit einer Schichtform aufweisenden Referenzelektrodenmaterial derart bedeckt ist, dass es in elektrischem Kontakt mit der elektrisch leitenden Metallfolie oder -platte steht, und mindestens eine nichtmetallische Lithiumverbindung innerhalb des Gehäuses beinhaltet,

EP 2 628 205 B1

wobei die Komponenten innerhalb eines Gehäuses abgedichtet sind, wobei die positive Elektrode und die negative Elektrode jeweils eine elektrisch leitende Struktur aufweisen, die sich ebenso wie die elektrisch leitende Metallfolie oder die elektrisch leitende Metallplatte der Referenzelektrode durch eine Wand des Gehäuses zur weiteren elektrischen Verbindung erstrecken,

die Methode einschließlich der folgenden Schritte:

(a) Anlegen einer konstanten Spannung zwischen der Kathode und der Anode
(b) Messen der Impedanz über mindestens eine der ZC-Ref- und ZA-Ref-Schleifen, wobei C die Kathode, A die Anode und Ref die Referenzelektrode ist.

15. Verfahren für eine Bewertung der Alterung von mindestens einer der Elektroden einer elektrochemischen Zelle, umfassend die Durchführung des Verfahrens nach Anspruch 14 und einschließlich der zusätzlichen Schritte:

(c) Beurteilen, ob die genannten Impedanzen innerhalb eines akzeptablen Bereichs liegen

- wenn nein, wird die Zelle terminiert;
- wenn ja, erneute Messung der Impedanz und Wiederholung der Schleife, und entweder

(d) Protokollieren des Impedanzanstiegs der Anode und der Kathode, um die Alterung beider abzuschätzen und dadurch die Lebensdauer der Zelle abzuschätzen, und/oder
(e) Abschätzen der Leistungsverluste an der Anode und/oder Kathode durch zugehörige Impedanzen.

16. Verfahren zum Betreiben einer elektrochemischen Zelle auf Basis der Lithiumtechnologie, das die folgenden Schritte umfasst:

- Bereitstellen einer elektrochemischen Zelle auf Basis der Lithiumtechnologie gemäß einem der Ansprüche 1 bis 10,
- Messen der Spannung zwischen

(i) der Anode und der Referenzelektrode ($\Delta V_{Anode}$) und/oder
(ii) der Kathode und der Referenzelektrode ($\Delta V_{Kathode}$),

- Prüfen, ob die genannten Spannungen innerhalb eines akzeptablen Bereichs liegen, und
- entweder, wenn ja, erneutes Messen der genannten Spannungen, falls erforderlich,
- oder, falls nein, Prüfen, ob das Ausmaß des Spannungsdurchbruchs über einen kritischen Punkt hinausgeht, und

- wenn ja, Beenden des Betriebes der Zelle, oder
- wenn nein, Variieren der Lade- und/oder Entladerate und anschließendes erneutes Messen der genannten Spannungen, falls erforderlich.

17. Verfahren zur Maximierung der Lebensdauer einer Batterie, das die folgenden Schritte umfasst:

- Bereitstellen einer elektrochemischen Zelle auf Basis der Lithiumtechnologie gemäß einem der Ansprüche 1 bis 10,
- Messen der Spannung zwischen

(i) der Anode und der Referenzelektrode ($\Delta V_{Anode}$) und/oder
(ii) der Kathode und der Referenzelektrode ($\Delta V_{Kathode}$),

- Bestimmen der Einzelspannungen an der Anode und der Kathode, und
- Bewerten, ob die genannten Spannungen zu hoch und/oder zu niedrig sind, und
- falls erforderlich, Korrigieren der an der Kathode und/oder Anode angelegten Spannung auf akzeptable Werte.

**Revendications**

1. Cellule électrochimique basée sur la technologie lithium, comprenant les composants suivants:

- une électrode positive contenant un matériau de cathode,
- un séparateur constitué d'un matériau électriquement isolant,
- une électrode négative contenant un matériau d'anode,

les électrodes et le séparateur étant en forme de feuille,

- un matériau conducteur d'ions liquide et/ou solide pour le transport d'ions lithium entre les électrodes positive et négative,

lesdits composants étant scellés à l'intérieur d'un boîtier, dans laquelle l'électrode positive et l'électrode négative comprennent chacune une structure électriquement conductrice qui s'étend à travers une paroi du boîtier en vue d'une connexion électrique supplémentaire,
**caractérisée en ce qu'**elle comprend en outre:
une électrode de référence à l'intérieur dudit boîtier qui est électriquement isolée des électrodes positive et négative et qui se situe à une distance d'au moins 1,5 mm par rapport à l'électrode voisine, l'électrode de référence comprenant un film ou une feuille métallique électriquement conducteur/conductrice qui s'étend à travers une paroi du boîtier en vue d'une connexion électrique supplémentaire et qui est recouvert(e) d'un matériau d'électrode de référence en forme de couche de telle sorte qu'il soit en contact électrique avec le film ou la feuille métallique électriquement conducteur/conductrice, et comprenant au moins un composé lithium non métallique à l'intérieur dudit boîtier.

2. Cellule électrochimique basée sur la technologie lithium selon la revendications 1, dans laquelle la distance entre les frontières de l'électrode de référence et celles de l'électrode voisine est d'au moins 1,6 mm, de préférence d'au moins 2,1 mm et plus préférablement d'au moins 2,8 mm.

3. Cellule électrochimique basée sur la technologie lithium selon l'une quelconque des revendications précédentes, dans laquelle l'électrode de référence est électriquement isolée de l'électrode négative et de l'électrode positive par l'intermédiaire du matériau de séparateur et/ou par l'intermédiaire d'un revêtement électriquement isolant qui est prévu sur l'électrode de référence et/ou sur une ou chacune des deux électrodes.

4. Cellule électrochimique basée sur la technologie lithium selon l'une quelconque des revendications précédentes, dans laquelle les électrodes et le séparateur sont agencés les uns au-dessus des autres dans la direction z, et couvrent chacun une surface dans une direction x-y, et si la batterie est vue du dessus (dans la direction z), l'électrode de référence est placée à l'extérieur de la surface qui est couverte par l'électrode positive et/ou l'électrode négative.

5. Cellule électrochimique basée sur la technologie lithium selon l'une quelconque des revendications précédentes, dans laquelle les électrodes et le séparateur sont agencés les uns au-dessus des autres dans la direction z, et couvrent chacun une surface dans une direction x-y, dans laquelle la longueur ou la largeur de la couche de séparateur est supérieure à celle des couches d'électrode, et les couches sont placées les unes au-dessus des autres de telle sorte que la couche de séparateur fasse saillie à partir des couches d'électrode sur un côté de la batterie, **caractérisée en ce que** l'électrode de référence est attachée à la couche de séparateur le long de sa longueur en saillie.

6. Cellule électrochimique basée sur la technologie lithium selon l'une quelconque des revendications précédentes, dans laquelle les électrodes et le séparateur sont agencés les uns au-dessus des autres dans la direction z, et couvrent chacun une surface dans une direction x-y, **caractérisée en ce qu'**au moins une des électrodes comporte un évidement ou une encoche découpée de la couche, et l'électrode de référence, vue dans la direction z, est placée dans la région de ladite encoche ou dudit évidement de l'une des électrodes.

7. Cellule électrochimique basée sur la technologie lithium selon la revendication 6, dans laquelle l'électrode de référence est placée sur l'un ou l'autre parmi le collecteur de courant de cathode et le collecteur de courant d'anode, séparée de celui-ci par un matériau isolant, de telle sorte qu'elle soit située à l'intérieur de l'évidement ou de l'encoche de l'électrode voisine.

8. Cellule électrochimique basée sur la technologie lithium selon l'une quelconque des revendications précédentes, dans laquelle le composé lithium non métallique est sélectionné de telle sorte que l'électrode présente un profil de la tension par rapport à une concentration en ions lithium qui est plat, et de préférence dans le groupe comprenant $Li_4Ti_5O_{12}$, $LiFePO_4$, $Li(Ni_{0,5}Mn_{1,5})O_4$, $LiMn_2O_4$ et $LiCo_{1/3}Ni_{1/3}Mn_{1/3}O_2$ (NMC).

9. Cellule électrochimique basée sur la technologie lithium selon l'une quelconque des revendications précédentes, dans laquelle le collecteur d'électrode de référence est recouvert par le matériau d'électrode de référence sur les deux côtés.

10. Cellule électrochimique basée sur la technologie lithium selon l'une quelconque des revendications précédentes, **caractérisée en ce qu'**elle contient deux ou plus de deux électrodes de référence.

11. Procédé de production d'une cellule électrochimique basée sur la technologie lithium selon l'une quelconque des revendications précédentes, comprenant les étapes suivantes:

   - prévoir une électrode positive connectée à une structure électriquement conductrice,
   - prévoir une électrode négative connectée à une structure électriquement conductrice,
   - prévoir une électrode de référence, l'électrode de référence comprenant un film ou une feuille métallique électriquement conducteur/conductrice recouvert(e) d'un matériau d'électrode de référence en forme de couche de telle sorte qu'il soit en contact électrique avec le film ou la feuille électriquement conducteur/conductrice, et comprenant au moins un composé lithium non métallique à l'intérieur dudit boîtier,
   - prévoir un séparateur constitué d'un matériau électriquement isolant,
   - agencer les électrodes et le séparateur suivant la formation d'une cellule électrochimique, dans lequel l'électrode de référence se situe à une distance d'au moins 1,5 mm par rapport à l'électrode voisine et est électriquement isolée des électrodes positive et négative, et
   - enfermer de façon étanche les composants de la cellule électrochimique à l'intérieur d'un boîtier de telle sorte qu'une structure électriquement conductrice de chacune des électrodes et le film ou la feuille métallique électriquement conducteur/conductrice de l'électrode de référence s'étendent à travers une paroi du boîtier en vue d'une connexion électrique supplémentaire.

12. Procédé de mesure de la tension d'une cathode et/ou d'une anode d'une cellule électrochimique basée sur la technologie lithium, dans lequel la cellule comprend les composants suivants:

   - une électrode positive contenant un matériau de cathode,
   - un séparateur constitué d'un matériau électriquement isolant,
   - une électrode négative contenant un matériau d'anode,

   les électrodes et le séparateur étant en forme de couche ou de feuille,

   - un matériau conducteur d'ions liquide et/ou solide pour le transport d'ions lithium entre les électrodes positive et négative,
   - une électrode de référence qui est électriquement isolée des électrodes positive et négative et qui se situe à une distance d'au moins 1,5 mm par rapport à l'électrode voisine, l'électrode de référence comprenant un film ou une feuille métallique électriquement conducteur/conductrice recouvert(e) d'un matériau d'électrode de référence en forme de couche de telle sorte qu'il soit en contact électrique avec le film ou la feuille métallique électriquement conducteur/conductrice, et comprenant au moins un composé lithium non métallique à l'intérieur dudit boîtier,

   lesdits composants étant scellés à l'intérieur d'un boîtier, dans lequel l'électrode positive et l'électrode négative comprennent chacune une structure électriquement conductrice qui, ainsi que le film ou la feuille métallique électriquement conducteur/conductrice de l'électrode de référence, s'étendent à travers une paroi du boîtier en vue d'une connexion électrique supplémentaire,
   le procédé comprenant les étapes suivantes:

   (a) charger et/ou décharger la cellule une fois ou plusieurs fois,
   (b) mesurer la tension entre la cathode et l'électrode de référence et/ou entre l'anode et l'électrode de référence une fois ou plusieurs fois, et ensuite
   (c) régler le potentiel de repos à une valeur souhaitée entre la valeur de charge et la valeur de décharge.

13. Procédé selon la revendication 12, dans lequel la tension à l'anode et/ou à la cathode est mesurée en mesurant la tension entre la cathode et l'électrode de référence ou la tension entre l'anode et l'électrode de référence, et un état de charge (SOC) de la cellule est dérivé de celle-ci, en utilisant une courbe de calibrage prédéterminée relative au SOC de la cellule par rapport à la tension à l'anode ou à la cathode.

**14.** Procédé de mesure de l'impédance d'une cathode et d'une anode d'une cellule électrochimique basée sur la technologie lithium de façon indépendante, **caractérisée en ce que** la cellule comprend les composants suivants:

- une électrode positive contenant un matériau de cathode,
- un séparateur constitué d'un matériau électriquement isolant,
- une électrode négative contenant un matériau d'anode,

les électrodes et le séparateur étant en forme de couche ou de feuille,
un matériau conducteur d'ions liquide et/ou solide pour le transport d'ions lithium entre les électrodes positive et négative,
une électrode de référence qui est électriquement isolée des électrodes positive et négative et qui se situe à une distance d'au moins 1,5 mm par rapport à l'électrode voisine, comprenant un film ou une feuille métallique électriquement conducteur/conductrice recouvert(e) d'un matériau d'électrode de référence en forme de couche de telle sorte qu'il soit en contact électrique avec le film ou la feuille métallique électriquement conducteur/conductrice, et comprenant au moins un composé lithium non métallique à l'intérieur dudit boîtier,
lesdits composants étant scellés à l'intérieur d'un boîtier, dans lequel l'électrode positive et l'électrode négative comprennent chacune une structure électriquement conductrice qui, ainsi que le film ou la feuille métallique électriquement conducteur/conductrice de l'électrode de référence, s'étendent à travers une paroi du boîtier en vue d'une connexion électrique supplémentaire,
le procédé comprenant les étapes suivantes:

(a) appliquer une tension constante entre la cathode et l'anode, et
(b) mesurer l'impédance à travers au moins une des boucles $Z_{C\text{-Réf}}$ et $Z_{A\text{-Réf}}$, dans lequel C est la cathode, A est l'anode, et Réf est l'électrode de référence.

**15.** Procédé d'évaluation du vieillissement d'au moins une des électrodes d'une cellule électrochimique, comprenant l'exécution du procédé selon la revendication 14, et comprenant les étapes supplémentaires:

(c) évaluer si lesdites impédances sont comprises à l'intérieur d'une plage acceptable:

- si ça n'est pas le cas, désactiver la cellule;
- si c'est le cas, mesurer à nouveau l'impédance et répéter la boucle, et soit:

(d) enregistrer l'augmentation de l'impédance de l'anode et de la cathode dans le but d'estimer le vieillissement de chacune d'elles et d'estimer de ce fait la durée de vie de la cellule, et/ou
(e) estimer les pertes de capacité de puissance au niveau de l'anode et/ou de la cathode par des impédances associées.

**16.** Procédé de commande d'une cellule électrochimique basée sur la technologie lithium, comprenant les étapes suivantes:

- prévoir une cellule électrochimique basée sur la technologie lithium selon l'une quelconque des revendications 1 à 10,
- mesurer la tension entre:

(i) l'anode et l'électrode de référence ($\Delta V_{anode}$), et/ou
(ii) la cathode et l'électrode de référence ($\Delta V_{cathode}$),

- vérifier si lesdites tensions sont comprises à l'intérieur d'une plage acceptable, et
- soit, si c'est le cas, mesurer à nouveau lesdites tensions, si nécessaire,
- soit, si ça n'est pas le cas, vérifier si la grandeur de la rupture de tension se situe au-delà d'un point critique, et

- si c'est le cas, mettre un terme au fonctionnement de la cellule, ou
- si ça n'est pas le cas, modifier le régime de charge et/ou le régime de décharge et mesurer ensuite à nouveau lesdites tensions, si nécessaire.

**17.** Procédé pour maximiser la durée de vie d'une batterie, comprenant les étapes suivantes:

- prévoir une cellule électrochimique basée sur la technologie lithium selon l'une quelconque des revendications 1 à 10,
- mesurer la tension entre:

    (i) l'anode et l'électrode de référence ($\Delta V_{anode}$) et/ou
    (ii) la cathode et l'électrode de référence ($\Delta V_{cathode}$),

- déterminer les tensions individuelles à l'anode et à la cathode, et
- évaluer si lesdites tensions sont trop élevées et/ou trop basses, et
- si nécessaire, corriger la tension appliquée à la cathode et/ou l'anode afin de la ramener à des valeurs acceptables.

**Fig. 1**

**Fig. 17**

Measure voltage between

i)    the anode and reference electrode ($\Delta V_{anode}$) and/or

ii)   cathode and reference electrode ($\Delta V_{cathode}$)

Are the voltages within acceptable range

Yes

No

Is the magnitude of voltage breach beyond critical point?

Yes

No

Vary charging rate and/or discharging rate

Terminate the operation of cell

**Fig. 2**

Measure impedance between
- the anode and reference electrode ($Z_{A\text{-}Ref}$) and/or
- cathode and reference electrode ($Z_{C\text{-}Ref}$)

Are $Z_{A\text{-}Ref}$ and $Z_{C\text{-}Ref}$ different from previous measurements?

No

No

Is the magnitude of the difference in impedances beyond the critical point?

Yes          No

Remeasure and recompare impedances

Terminate the operation of cell (optional: post-mortem analysis)

Yes

Is the magnitude of the difference in impedances beyond the critical point?

No

Is the difference greater than in the previous measurement?

No

Yes

Estimate the battery life based on the trend in impedance rise and deactivate the battery as appropriate

**Fig. 3**

A)

B)

Fig. 4

**Fig. 5**

reference tab

Full-cell

**Fig. 6a)**

Reference electrode

Cathode/anode

D (Diffusion barrier)

**Fig. 6b)**

Fig. 7

Fig. 8

**Fig. 9**

Fig. 10

Fig. 11

anode/cathode
current
collector

+

anode/cathode
material

Y

X>Y

+

separator

X

reference electrode
alligned along the
full length of the
separator edge

+

cathode/anode
material

+

cathode/anode
current
collector

Full-cell

reference
electrode

Fig. 12

EP 2 628 205 B1

Fig. 13

anode/cathode current collector + anode/cathode material + separator + cathode/anode material + cathode/anode current collector

Full-cell

reference tab

top-view of reference electrode plane

Reference electrode

reference electrodes

cut

*Insulated backside of reference electrode prevents electrical short*

Reference electrode material + electrical conductor foil with backside and one edge with electrical insulation

edge insulation

lamination/ bonding

Fig. 14

Fig. 15

EP 2 628 205 B1

(A)

(B)

# Fig. 16

**Fig. 18a)**

**Fig. 18b)**

Fig. 19a)

Fig. 19b)

**Fig. 19c)**

Fig. 20a)

Fig. 20b)

Fig. 20c)

Fig. 21

Fig. 22

Fig. 23

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3103480 A
- US 4282081 A
- US 4401548 A
- WO 2009036444 A2
- JP 2007193986 A

**Non-patent literature cited in the description**

- **D. W. DEES ; A. N. JANSEN ; D. P. ABRAHAMS.** *J. Power Sources,* 2007, vol. 174, 1001
- **D.P. ABRAHAM ; R. E. REYNOLDS ; E. SAMMANN ; A. N. JANSEN ; D. W. DEES.** *Electrochim. Acta,* 2005, vol. 51, 502
- **D.P. ABRAHAM ; S.D. POPPEN ; A. N. JANSEN ; J. LIU ; D. W. DEES.** *Electrochim. Acta,* 2004, vol. 49, 4763-4775
- *J. Electrochem. Soc.,* 1996, vol. 143, 1890
- *Angew. Chem. Int. Ed. Engl.,* 1993, vol. 32, 1268
- **A. J. BARD ; L. R. FAULKNER.** Electrochemical Methods: Fundamentals and Applications. John Wiley & Sons, 2000
- **H. NOZAKI et al.** *J. Power Sources,* 2009, vol. 194, 486-493
- **S-M. PARK ; J-K YOO.** *Anal. Chem.,* 2003, vol. 75, 455 A
- **DANA A. TOTIR ; BORIS D. CAHAN ; DANIEL A. SCHERSON.** *Electrochimica Acta,* 1999, vol. 45, 161-166
- **H. WANG ; M. YOSHIO.** *Journal of Power Sources,* 2001, vol. 93, 123-129